# EUROPEAN PATENT SPECIFICATION

(11) **EP 4 401 536 B1**
(45) Date of publication and mention of the grant of the patent: **25.11.2026**
(21) Application number: 23747360.8
(22) Date of filing: 26.01.2023
(51) Int. Cl.: H10K 85/60, H10K 50/11, C09K 11/06, H10K 50/00, H10K 101/00, H10K 101/10

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 26.01.2022 KR 20220011716
(43) Date of publication of application: 17.07.2024
(73) Proprietor: LG Chem, Ltd., Yeongdeungpo-gu Seoul 07336 (KR)
(72) Inventor: JUNG, Min Woo, Daejeon 34122 (KR); LEE, Dong Hoon, Daejeon 34122 (KR); HAN, Miyeon, Daejeon 34122 (KR); PARK, Seulchan, Daejeon 34122 (KR); KIM, Hoon Jun, Daejeon 34122 (KR); CHO, Hye Min, Daejeon 34122 (KR); LEE, Hojung, Daejeon 34122 (KR)
(74) Representative: Hoffmann Eitle
(86) International application number: PCT/KR2023/001224
(87) International publication number: WO 2023/146319

(56) References cited:
- WO-A1-2021/029616
- CN-A- 112 789 747
- KR-A- 20180 010 149
- KR-A- 20180 010 149
- KR-A- 20190 079 341
- KR-A- 20210 018 127
- KR-A- 20210 041 835
- KR-A- 20220 009 351

## Description

### [TECHNICAL FIELD]

The present disclosure relates to an organic light emitting device having improved driving voltage, efficiency and lifetime.

### [BACKGROUND ART]

In general, an organic light emitting phenomenon refers to a phenomenon where electric energy is converted into light energy by using an organic material. The organic light emitting device using the organic light emitting phenomenon has characteristics such as a wide viewing angle, an excellent contrast, a fast response time, an excellent luminance, driving voltage and response speed, and thus many studies have proceeded.

The organic light emitting device generally has a structure which comprises an anode, a cathode, and an organic material layer interposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, an electron injection layer and the like. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again.

In the organic light emitting device as described above, there is a continuing need for the development of an organic light emitting device having improved driving voltage, efficiency and lifetime.

### [Prior Art Literature]

### [Patent Literature]

(Patent Literature 0001) Korean Unexamined Patent Publication No. 10-2000-0051 826.

WO 2021/029616 A1 relates to an organic light-emitting device having improved driving voltage and/or service life by comprising two types of host compounds in a light-emitting layer.

KR 2018 0010149 A relates to a heterocyclic compound and an organic light emitting device comprising the same with a compound represented by chemical formula 1 and used as a material for an organic layer in an organic light emitting device.

### [DETAILED DESCRIPTION OF THE INVENTION]

### [Technical Problem]

It is an object of the present disclosure to provide an organic light emitting device having improved driving voltage, efficiency and lifetime.

### [Technical Solution]

The present disclosure provides the following organic light emitting device:
An organic light emitting device comprising:
an anode;
a cathode; and
a light emitting layer interposed between the anode and the cathode,
wherein the light emitting layer includes a compound represented by the following Chemical Formula 1, and a compound represented by the following Chemical Formula 2. 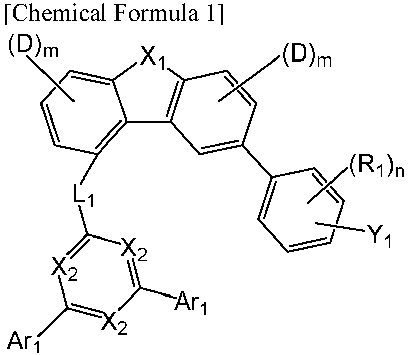
wherein, in Chemical Formula 1,
X₁ is O or S,
L₁ is a single bond, a substituted or unsubstituted C₆₋₆₀ arylene, or a substituted or unsubstituted C₂₋₆₀ heteroarylene containing any one or more heteroatoms selected from the group consisting of N, O, and S,
each X₂ is independently N or CH, provided that at least one of X₂ is N,
each Ar₁ is independently a substituted or unsubstituted C₆₋₆₀ aryl, or a substituted or unsubstituted C₂₋₆₀ heteroaryl containing any one or more heteroatoms selected from the group consisting of N, O, and S,
each R₁ is independently hydrogen, deuterium, or a substituted or unsubstituted C₆₋₆₀ aryl,
Y₁ is the following group 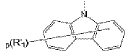
wherein, in the above group, each R'1 is independently deuterium, or phenyl which is substituted with at least one deuterium, and
p is an integer of 1 to 10,
m is each independently an integer of 0 to 3, and
n is an integer of 0 to 4. 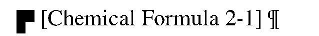 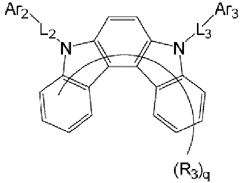
wherein, in Chemical Formula 2-1,
L₂ and L₃ are each independently a single bond, or a substituted or unsubstituted C₆₋₆₀ arylene,
Ar₂ and Ar₃ are each independently a substituted or unsubstituted C₆₋₆₀ aryl, or a substituted or unsubstituted C₂₋₆₀ heteroaryl containing any one or more heteroatoms selected from the group consisting of N, O, and S,
each R₃ is each independently hydrogen, deuterium, a substituted or unsubstituted C₆₋₆₀ aryl, or a substituted or unsubstituted C₂₋₆₀ heteroaryl containing any one or more heteroatoms selected from the group consisting of N, O, and S,
at least one of the L₂, L₃, Ar₂ and Ar₃ is substituted with at least one deuterium, or at least one of the R₃ is deuterium, and
q is an integer of 1 to 10.

### [Advantageous Effects]

The organic light emitting device described above is excellent in driving voltage, efficiency and lifetime.

### [BRIEF DESCRIPTION OF THE DRAWINGS]

FIG. 1 shows an example of an organic light emitting device comprising a substrate 1, an anode 2, a light emitting layer 3, and a cathode 4.
FIG. 2 shows an example of an organic light emitting device comprising a substrate 1, an anode 2, a hole injection layer 5, a hole transport layer 6, an electron blocking layer 7, a light emitting layer 3, a hole blocking layer 8, an electron transport layer 9, an electron injection layer 10, and a cathode 4.

### [DETAILED DESCRIPTION OF THE EMBODIMENTS]

Hereinafter, embodiments of the present disclosure will be described in more detail to facilitate understanding of the invention.

As used herein, the notation 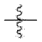 or 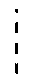 means a bond linked to another substituent group, and "D" means deuterium.

As used herein, the term "substituted or unsubstituted" means being unsubstituted or substituted with one or more substituent groups selected from the group consisting of deuterium; a halogen group; a cyano group; a nitro group; a hydroxy group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; and a heterocyclic group containing at least one of N, O and S atoms, or being unsubstituted or substituted with a substituent group to which two or more substituent groups of the above-exemplified substituent groups are linked. For example, "a substituent group in which two or more substituents are linked" may be a biphenylyl group. Namely, a biphenylyl group may be an aryl group, or it may be interpreted as a substituent group in which two phenyl groups are linked. In one example, "a substituent in which two or more substituents are linked" may be a biphenyl group. Namely, a biphenylyl group may be an aryl group, or it may also be interpreted as a substituent in which two phenyl groups are linked. In one example, the term "substituted or unsubstituted" may be understood as meaning "being unsubstituted or substituted with one or more substituents selected from the group consisting of deuterium, halogen, cyano, a C₁₋₁₀ alkyl, a C₁₋₁₀ alkoxy and a C₆₋₂₀ aryl", or "being unsubstituted or substituted with one or more substituents selected from the group consisting of deuterium, halogen, cyano, methyl, ethyl, phenyl and naphthyl". Also, the term "substituted with one or more substituents" as used herein may be understood as meaning "being substituted with mono to the maximum number of substitutable hydrogens". Alternatively, the term "substituted with one or more substituents" as used herein may be understood as meaning "being substituted with 1 to 5 substituents", or "being substituted with one or two substituents".

In the present disclosure, the carbon number of a carbonyl group is not particularly limited, but is preferably 1 to 40. Specifically, the carbonyl group may be a substituent group having the following structural formulas, but is not limited thereto.

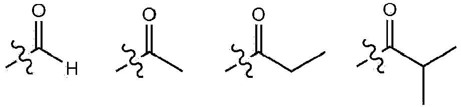

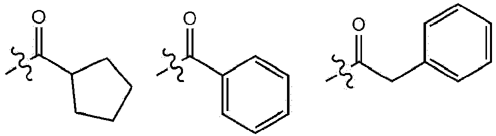

In the present disclosure, an ester group may have a structure in which oxygen of the ester group may be substituted by a straight-chain, branched-chain, or cyclic alkyl group having 1 to 25 carbon atoms, or an aryl group having 6 to 25 carbon atoms. Specifically, the ester group may be a substituent group having the following structural formulas, but is not limited thereto.

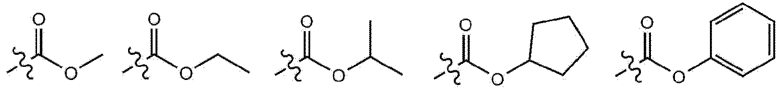

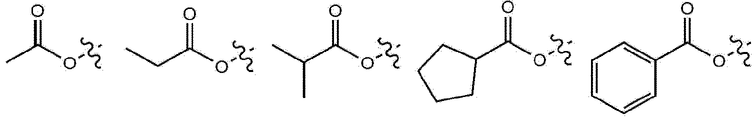

In the present disclosure, the carbon number of an imide group is not particularly limited, but is preferably 1 to 25. Specifically, the imide group may be a substituent group having the following structural formulas, but is not limited thereto.

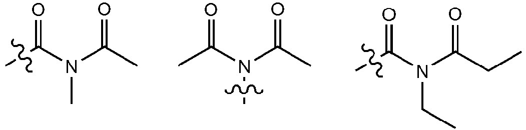

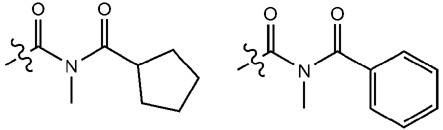

In the present disclosure, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group and the like, but is not limited thereto.

In the present disclosure, a boron group specifically includes a trimethylboron group, a triethylboron group, a t-butyldimethylboron group, a triphenylboron group, and a phenylboron group, but is not limited thereto.

In the present disclosure, examples of a halogen group include fluorine, chlorine, bromine, or iodine.

In the present disclosure, the alkyl group may be straight-chain or branched-chain, and the carbon number thereof is not particularly limited, but is preferably 1 to 40. According to one embodiment, the carbon number of the alkyl group is 1 to 20. According to another embodiment, the carbon number of the alkyl group is 1 to 10. According to another embodiment, the carbon number of the alkyl group is 1 to 6. Specific examples of the alkyl group include methyl, ethyl, propyl, n-propyl, isopropyl, butyl, n-butyl, isobutyl, tert-butyl, sec-butyl, 1-methyl-butyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 4-methylhexyl, 5-methylhexyl, and the like, but are not limited thereto.

**In** the present disclosure, the alkenyl group may be straight-chain or branched-chain, and the carbon number thereof is not particularly limited, but is preferably 2 to 40. According to one embodiment, the carbon number of the alkenyl group is 2 to 20. According to another embodiment, the carbon number of the alkenyl group is 2 to 10. According to still another embodiment, the carbon number of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present disclosure, a cycloalkyl group is not particularly limited, but the carbon number thereof is preferably 3 to 60. According to one embodiment, the carbon number of the cycloalkyl group is 3 to 30. According to another embodiment, the carbon number of the cycloalkyl group is 3 to 20. According to still another embodiment, the carbon number of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present disclosure, an aryl group is not particularly limited, but the carbon number thereof is preferably 6 to 60, and it may be a monocyclic aryl group or a polycyclic aryl group. According to one embodiment, the carbon number of the aryl group is 6 to 30. According to one embodiment, the carbon number of the aryl group is 6 to 20. The aryl group may be a phenyl group, a biphenyl group, a terphenyl group or the like as the monocyclic aryl group, but is not limited thereto. The polycyclic aryl group includes a naphthyl group, an anthracenyl group, a phenanthrenyl group, a pyrenyl group, a perylenyl group, a chrysenyl group, or the like, but is not limited thereto.

In the present disclosure, the fluorenyl group may be substituted, and two substituent groups may be linked with each other to form a spiro structure. In the case where the fluorenyl group is substituted, 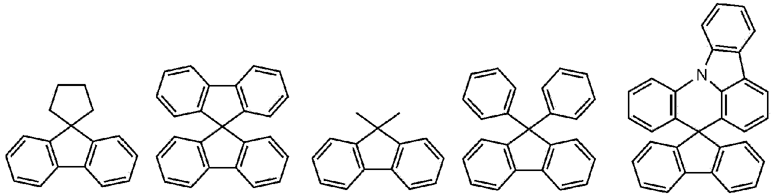 and the like can be formed. However, the structure is not limited thereto.

In the present disclosure, a heterocyclic group is a heterocyclic group containing one or more of O, N, Si and S as a heteroatom, and the carbon number thereof is not particularly limited, but is preferably 2 to 60. Examples of the heterocyclic group include a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzoimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group, and the like, but are not limited thereto.

In the present disclosure, the aryl group in the aralkyl group, the aralkenyl group, the alkylaryl group and the arylamine group is the same as the aforementioned examples of the aryl group. In the present disclosure, the alkyl group in the aralkyl group, the alkylaryl group and the alkylamine group is the same as the aforementioned examples of the alkyl group. In the present disclosure, the heteroaryl in the heteroarylamine can be applied to the aforementioned description of the heterocyclic group. In the present disclosure, the alkenyl group in the aralkenyl group is the same as the aforementioned examples of the alkenyl group. In the present disclosure, the aforementioned description of the aryl group may be applied except that the arylene is a divalent group. In the present disclosure, the aforementioned description of the heterocyclic group can be applied except that the heteroarylene is a divalent group. In the present disclosure, the aforementioned description of the aryl group or cycloalkyl group can be applied except that the hydrocarbon ring is not a monovalent group but formed by combining two substituent groups. In the present disclosure, the aforementioned description of the heterocyclic group can be applied, except that the heterocycle is not a monovalent group but formed by combining two substituent groups.

In the present disclosure, the term "deuterated or substituted with deuterium" means that at least one of the substitutable hydrogens in a compound, a divalent linking group, or a monovalent substituent has been substituted with deuterium.

Also, the term "unsubstituted or substituted with deuterium" or "substituted or unsubstituted with deuterium" means that "mono to the maximum number of unsubstituted or substitutable hydrogens have been substituted with deuterium." In one example, the term "phenanthryl unsubstituted or substituted with deuterium" may be understood as meaning "phenanthryl unsubstituted or substituted with 1 to 9 deuterium atoms", considering that the maximum number of hydrogens that can be substituted with deuterium in the phenanthryl structure is 9.

In addition, the "deuterium substitution rate" or "degree of deuteration" of a compound means that the ratio of the number of substituted deuterium atoms to the total number of hydrogen atoms (the sum of the number of hydrogen atoms substitutable with deuterium and the number of substituted deuterium atoms in a compound) that can be present in the compound is calculated as a percentage. Therefore, when the "deuterium substitution rate" or "degree of deuteration" of a compound is "K%", it means that K% of the hydrogen atoms substitutable with deuterium in the compound are substituted with deuterium.

At this time, the "deuterium substitution rate" or "degree of deuteration" can be measured according to a commonly known method using MALDI-TOF MS (Matrix-Assisted Laser Desorption/Ionization Time-of-Flight Mass Spectrometer), a nuclear magnetic resonance spectroscopy (¹H NMR), TLC/MS (Thin-Layer Chromatography/Mass Spectrometry), GC/MS (Gas Chromatography/Mass Spectrometry), or the like. More specifically, when using MALDI-TOF MS, the "deuterium substitution rate" or "degree of deuteration" is obtained by determining the number of substituted deuterium atoms in the compound through MALDI-TOF MS analysis, and then calculating the ratio of the number of substituted deuterium atoms to the total number of hydrogen atoms that can be present in the compound as a percentage.

Hereinafter, the present disclosure will be described in detail for each configuration.

### Anode and Cathode

An anode and a cathode used in the present disclosure mean electrodes used in an organic light emitting device.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides, such as ZnO:Al or SnO₂:Sb; conductive polymers such as poly(3-methylthiophene), poly[3,4-(ethylene-1,2-dioxy)thiophene](PEDOT), polypyrrole, and polyaniline, and the like, but are not limited thereto.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/Al or LiO₂/Al, and the like, but are not limited thereto.

### Light Emitting Layer

The light emitting layer used in the present disclosure is a layer that can emit light in the visible light region by combining holes and electrons transported from the anode and the cathode. Generally, the light emitting layer includes a host material and a dopant material, and in the present disclosure, the compound represented by Chemical Formula 1 and the compound represented by Chemical Formula 2-1 are included together as a host.

In Chemical Formula 1, preferably, L₁ is a single bond.

Preferably, X₂ is all N.

Preferably, each Ar₁ is independently phenyl which is unsubstituted or substituted with at least one deuterium, or biphenylyl which is unsubstituted or substituted with at least one deuterium.

Preferably, each R₁ is independently hydrogen, deuterium, or phenyl which is unsubstituted or substituted with at least one deuterium.

Preferably, Y₁ is any one selected from the group consisting of: 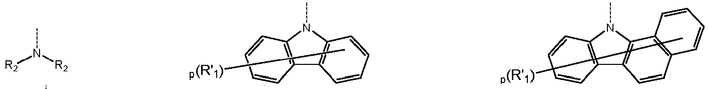 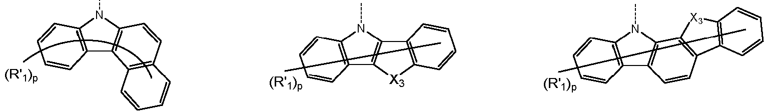 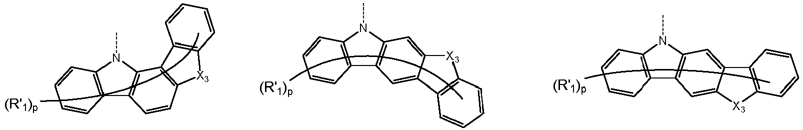 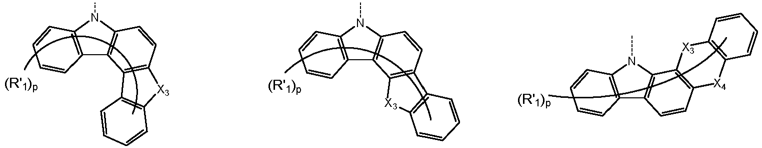 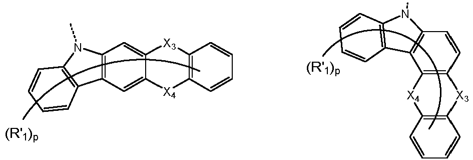
wherein, in the above group,
each R₂ is independently hydrogen, deuterium, or phenyl,
X₃ and X₄ are each independently O, N-(phenyl), S, or C(CH₃)₂,
each R'₁ is independently hydrogen, deuterium, or phenyl which is unsubstituted or substituted with at least one deuterium, and
p is an integer of 0 to 10.

When the compound represented by Chemical Formula 1 contains deuterium, the deuterium substitution rate of the compound may be 1% to 100%. Specifically, the deuterium substitution rate of the compound may be 5% or more, 10% or more, 20% or more, 30% or more, 40% or more, or 50% or more, and 100% or less, 90% or less, 80% or less, 70% or less, or 60% or less.

In one example, the compound represented by Chemical Formula 1 does contain 1 to 50 deuterium atoms. More specifically, the compound does contain 1 or more, 2 or more, 3 or more, 4 or more, 5 or more, 6 or more, 7 or more, 8 or more, or 9 or more, and 50 or less, 40 or less, 30 or less, 28 or less, 26 or less, 24 or less, 22 or less, 20 or less, 18 or less, 16 or less, 14 or less, 13 or less, 12 or less, 11 or less, or 10 or less.

Representative examples of the compound represented by Chemical Formula 1 are as follows:

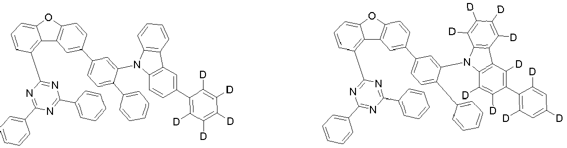

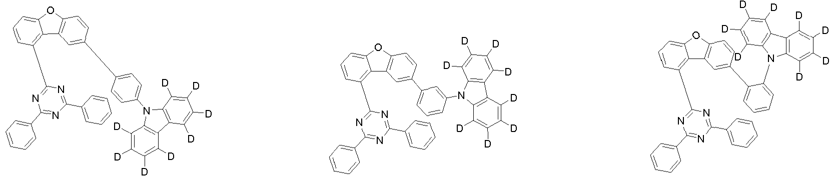

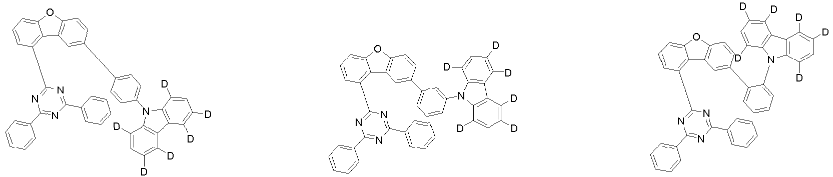

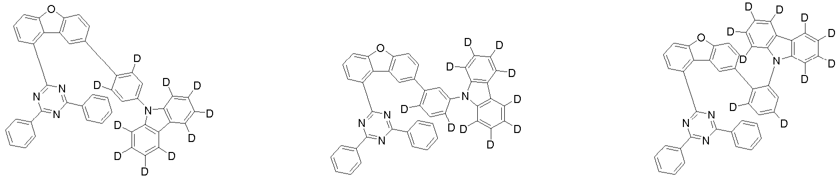

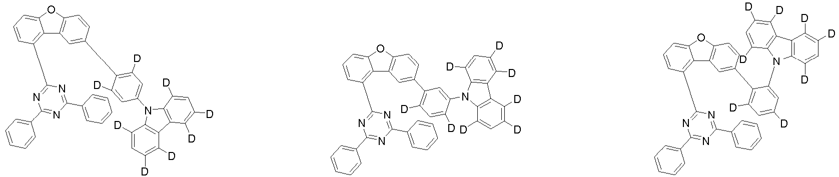

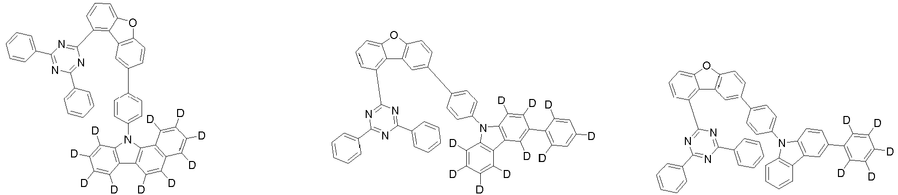

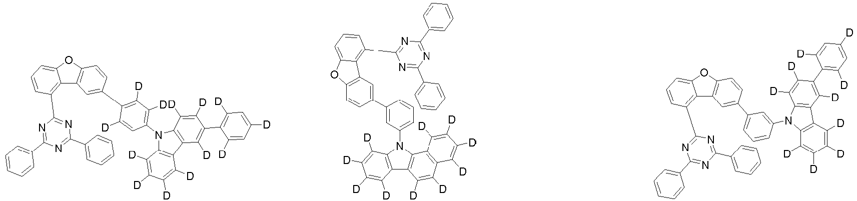

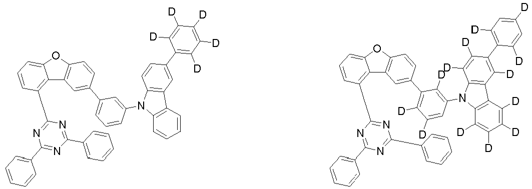

Representative examples of the compound represented by Chemical Formula 2-1 are as follows: 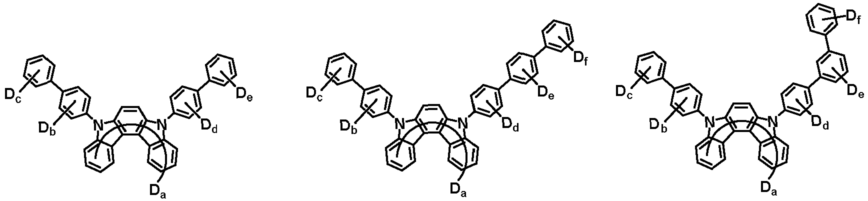 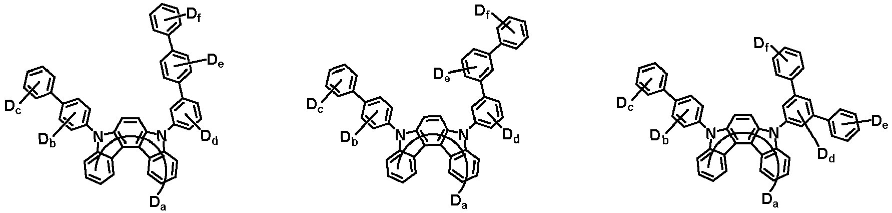 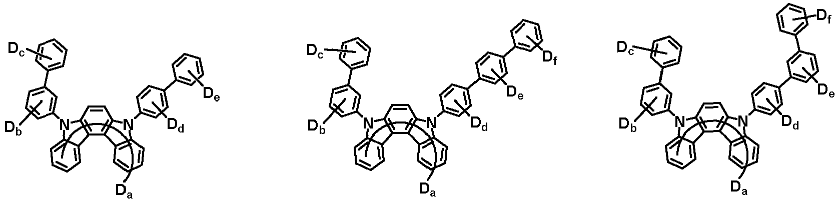 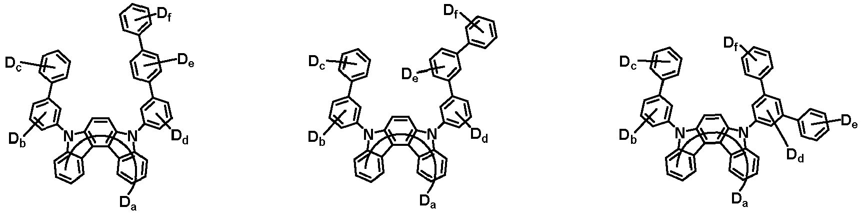 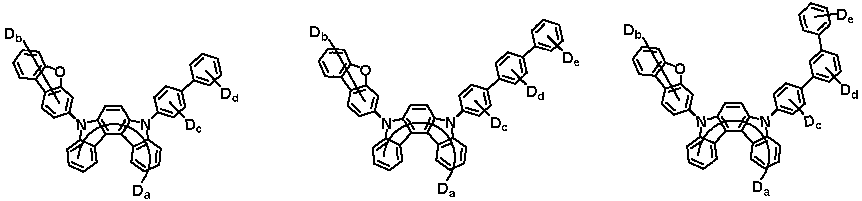 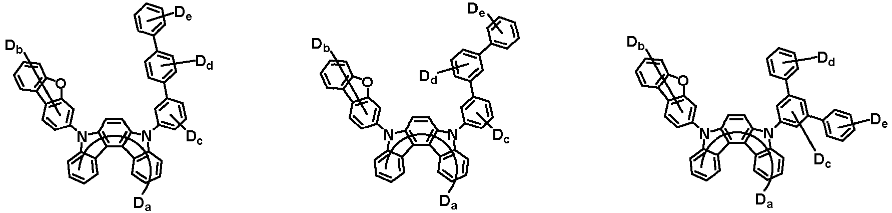 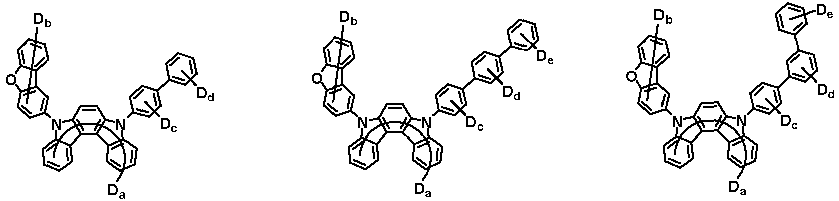 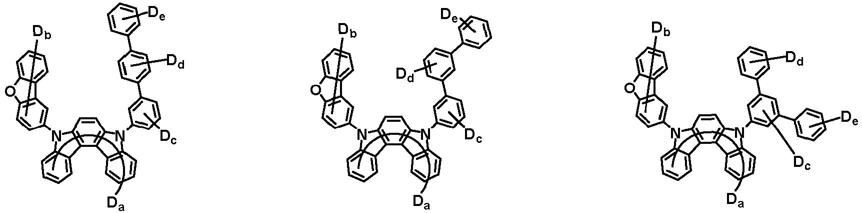 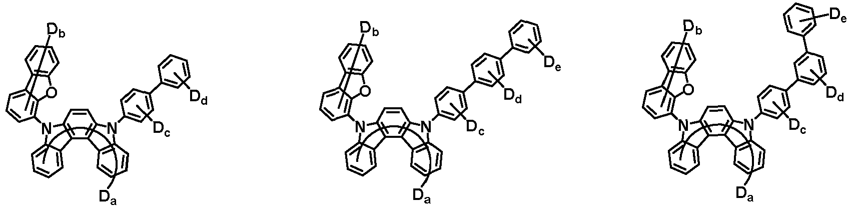 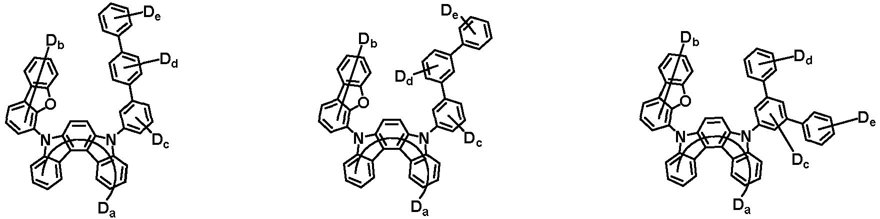 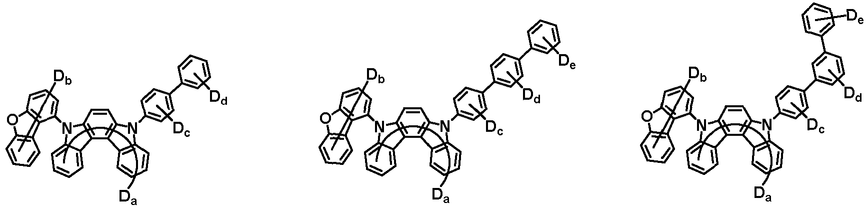 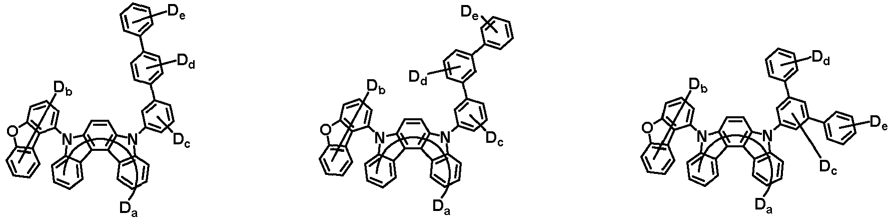 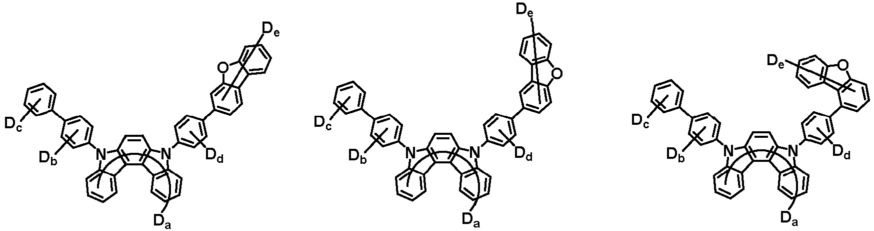 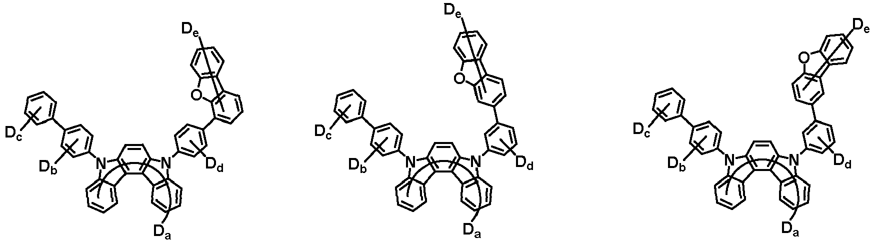 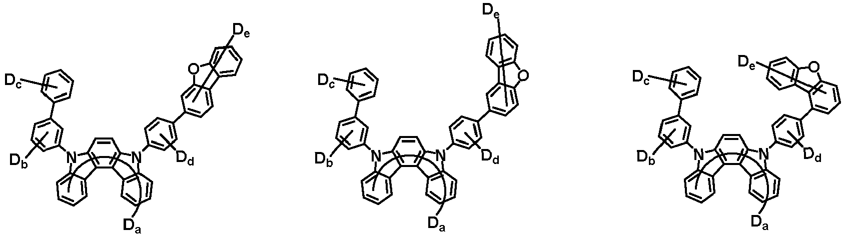 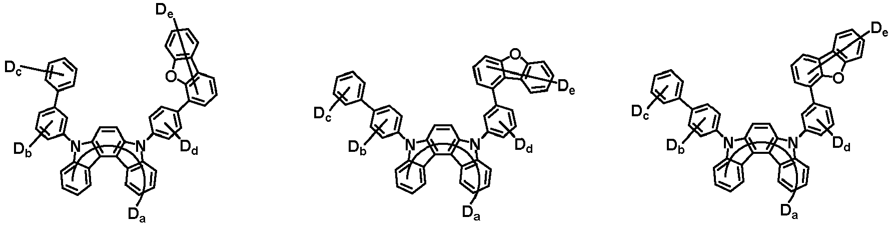 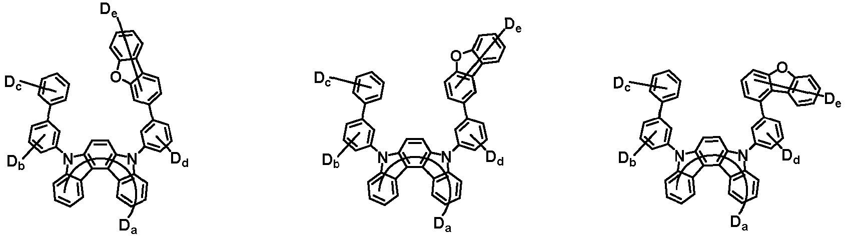 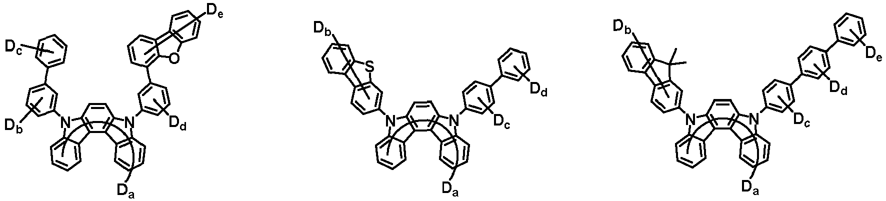 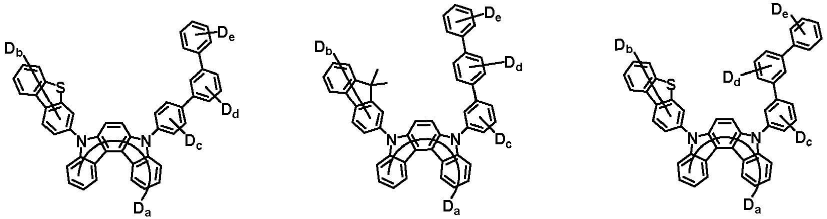 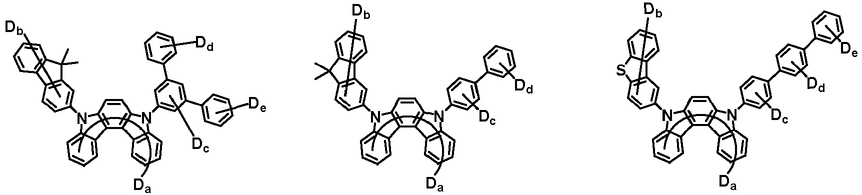 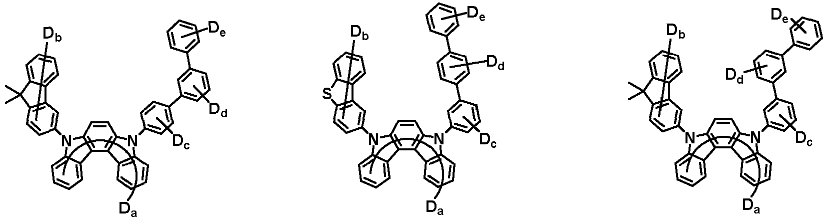 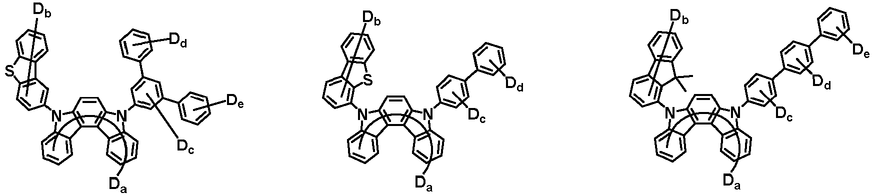 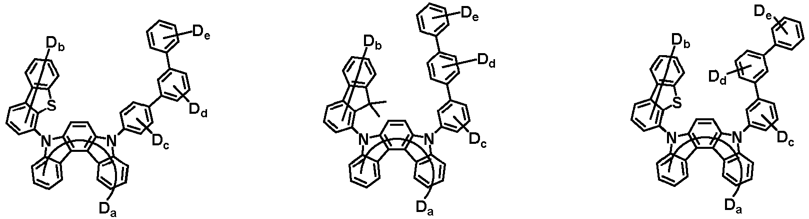 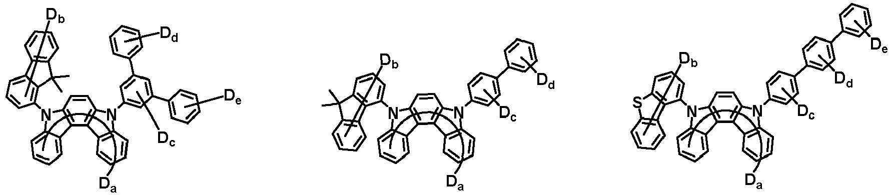 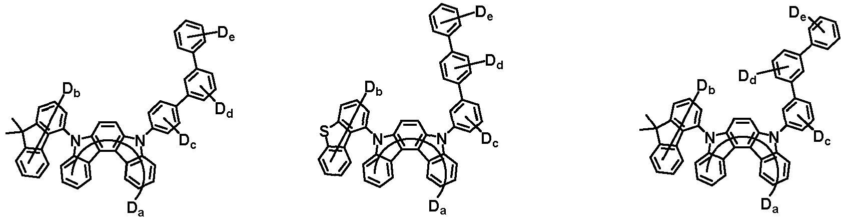 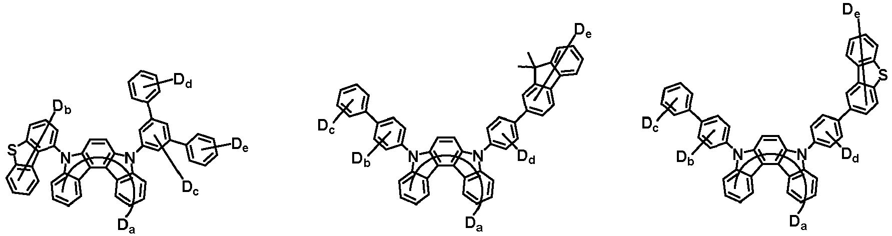 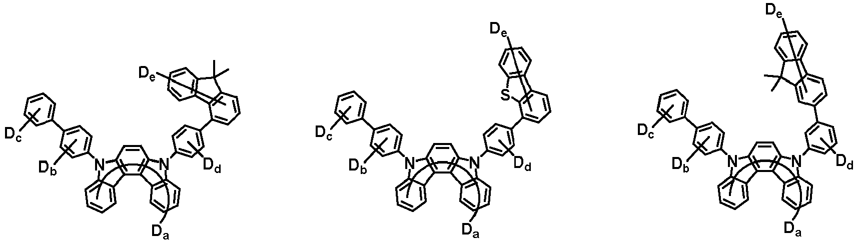 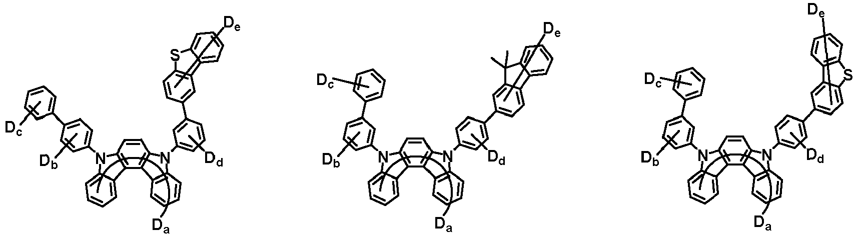 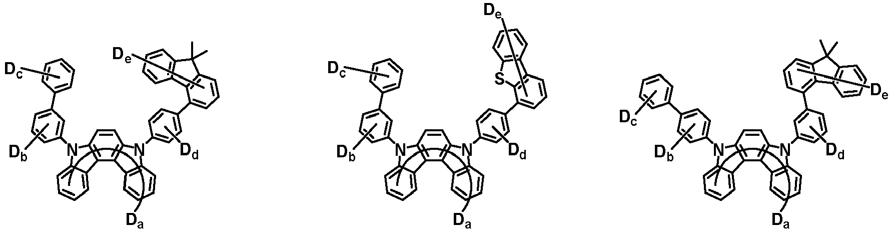 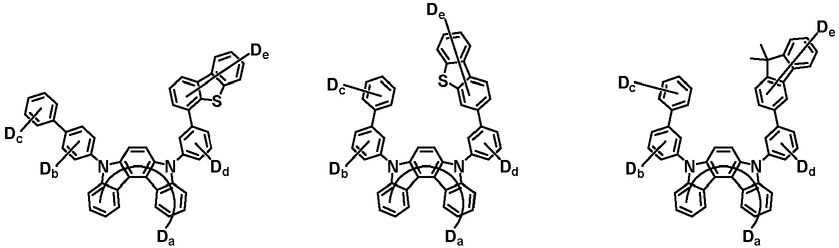 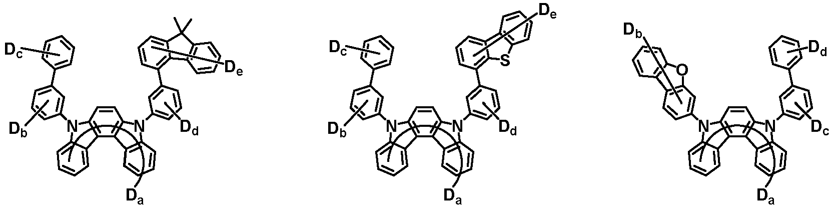
wherein, in the above group,
a is an integer of 0 to 10,
b is an integer of 0 to 7,
c is an integer of 0 to 5,
d is an integer of 0 to 5,
e is an integer of 0 to 7,
f is an integer of 0 to 5,
provided that the sum of a to f is 1 or more.

In the above group, each compound is substituted with at least one deuterium.

Meanwhile, the dopant material is not particularly limited as long as it is a material used for the organic light emitting device. As an example, an aromatic amine derivative, a styrylamine compound, a boron complex, a fluoranthene compound, a metal complex, and the like can be mentioned. Specific examples of the aromatic amine derivatives include substituted or unsubstituted fused aromatic ring derivatives having a substituted or unsubstituted arylamino group, examples of which include pyrene, anthracene, chrysene, and periflanthene having the arylamino group, and the like. The styrylamine compound is a compound where at least one arylvinyl group is substituted in a substituted or unsubstituted arylamine, in which one or two or more substituent groups selected from the group consisting of an aryl group, a silyl group, an alkyl group, a cycloalkyl group, and an arylamino group are substituted or unsubstituted. Specific examples thereof include styrylamine, styryldiamine, styryltriamine, styryltetramine, and the like, but are not limited thereto. Further, examples of the metal complex include an iridium complex, a platinum complex, and the like, but are not limited thereto.

### Hole Transport Layer

The organic light emitting device according to the present disclosure may include a hole transport layer interposed between the light emitting layer and the anode.

The hole transport layer is a layer that receives holes from a hole injection layer and transports the holes to the light emitting layer. The hole transport material is suitably a material having large mobility to the holes, which can receive injection of holes from the anode or the hole injection layer and transfer the holes to the light emitting layer.

Specific examples of the hole transport material include an arylamine-based organic material, a conductive polymer, a block copolymer in which a conjugate portion and a non-conjugate portion are present together, and the like, but are not limited thereto.

### Hole injection layer

The organic light emitting device according to the present disclosure may further include a hole injection layer interposed between the anode and the hole transport layer, if necessary.

The hole injection layer is a layer injecting holes from an electrode, and the hole injection material is preferably a compound which has a capability of transporting the holes, has a hole injection effect in the anode and an excellent hole injection effect to the light emitting layer or the light emitting material, prevents movement of an exciton generated in the light emitting layer to the electron injection layer or the electron injection material, and is excellent in the ability to form a thin film. Further, it is preferable that a HOMO (highest occupied molecular orbital) of the hole injection material is between the work function of the anode material and a HOMO of a peripheral organic material layer.

Specific examples of the hole injection material include metal porphyrin, oligothiophene, an arylamine-based organic material, a hexanitrilehexaazatriphenylene-based organic material, a quinacridone-based organic material, a perylene-based organic material, anthraquinone, polyaniline and polythiophene-based conductive polymer, and the like, but are not limited thereto.

### Electron Blocking Layer

The electron blocking layer refers to a layer which is formed on the hole transport layer, preferably provided in contact with the light emitting layer, and serves to adjust the hole mobility, prevent excessive movement of electrons, and increase the probability of hole-electron coupling, thereby improving the efficiency of the organic light emitting device.

The electron blocking layer includes an electron blocking material, and as such an electron blocking material, a material having a stable structure that prevents electrons from flowing out of the light emitting layer is suitable.

Specific examples of such electron blocking material may include an arylamine-based organic material or the like, but is not limited thereto.

### Hole Blocking Layer

The hole blocking layer refers to a layer which is formed on the light emitting layer, and specifically, is provided in contact with the light emitting layer, and thus severs to prevent excessive movement of holes, and to increase the probability of hole-electron bonding, thereby improving the efficiency of the organic light emitting device. The hole blocking layer includes a hole blocking material, and as such a hole blocking material, a material having a stable structure that prevents holes from flowing out of the light emitting layer is suitable.

As the hole blocking material, a compound into which an electron-withdrawing group is introduced, such as azine derivatives including triazine; triazole derivatives; oxadiazole derivatives; phenanthroline derivatives; phosphine oxide derivatives can be used, but is not limited thereto.

### Electron Transport Layer

The organic light emitting device according to the present disclosure may include an electron transport layer interposed between the light emitting layer and the cathode.

The electron transport layer is a layer that receives the electrons from the cathode or the electron injection layer formed on the cathode and transports the electrons to the light emitting layer, and that suppress the transfer of holes from the light emitting layer, and an electron transport material is suitably a material which may receive well injection of electrons from a cathode and transfer the electrons to a light emitting layer, and has a large mobility for electrons.

Specific examples of the electron transport material include: an Al complex of 8-hydroxyquinoline; a complex including Alq₃; an organic radical compound; a hydroxyflavone-metal complex, and the like, but are not limited thereto. The electron transport layer may be used with any desired cathode material, as used according to a conventional technique. In particular, appropriate examples of the cathode material are a typical material which has a low work function, followed by an aluminum layer or a silver layer. Specific examples thereof include cesium, barium, calcium, ytterbium, and samarium, in each case followed by an aluminum layer or a silver layer.

### Electron Injection Layer

The organic light emitting device according to the present disclosure may further include an electron injection layer interposed between the electron transport layer and the cathode.

The electron injection layer is a layer which injects electrons from an electrode, and is preferably a compound which has a capability of transporting electrons, has an effect of injecting electrons from a cathode and an excellent effect of injecting electrons into a light emitting layer or a light emitting material, prevents excitons produced from the light emitting layer from moving to a hole injection layer, and is also excellent in the ability to form a thin film.

Specific examples of the electron injection layer include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, a metal complex compound, a nitrogen-containing 5-membered ring derivative, and the like, but are not limited thereto.

Examples of the metal complex compound include 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-hydroxyquinolinato)chlorogallium, bis(2-methyl-8-hydroxyquinolinato)(o-cresolato)gallium, bis(2-methyl-8-hydroxyquinolinato)(1-naphtholato)aluminum, bis(2-methyl-8-hydroxyquinolinato)(2-naphtholato)gallium, and the like, but are not limited thereto.

### Organic Light Emitting Device

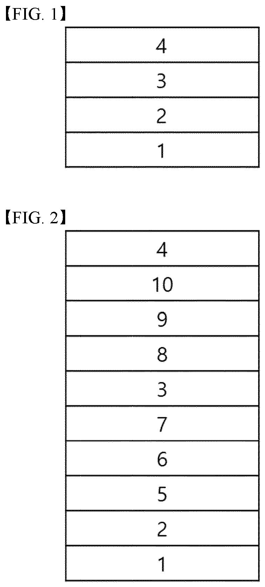

The structure of the organic light emitting device according to the present disclosure is illustrated in FIG. 1. FIG. 1 shows an example of an organic light emitting device comprising a substrate 1, an anode 2, a light emitting layer 3, and a cathode 4. FIG. 2 shows an example of an organic light emitting device comprising a substrate 1, an anode 2, a hole injection layer 5, a hole transport layer 6, an electron blocking layer 7, a light emitting layer 3, a hole blocking layer 8, an electron transport layer 9, an electron injection layer 10, and a cathode 4.

The organic light emitting device according to the present disclosure can be manufactured by sequentially stacking the above-described structures. In this case, the organic light emitting device may be manufactured by depositing a metal, metal oxides having conductivity, or an alloy thereof on the substrate by using a PVD (physical vapor deposition) method such as a sputtering method or an e-beam evaporation method to form the anode, forming the respective layers described above thereon, and then depositing a material that can be used as the cathode thereon. In addition to such a method, the organic light emitting device can be manufactured by sequentially depositing from the cathode material to the anode material on a substrate in the reverse order of the above-mentioned configuration (WO 2003/012890). Further, the light emitting layer may be formed by subjecting hosts and dopants to a vacuum deposition method and a solution coating method. Herein, the solution coating method means a spin coating, a dip coating, a doctor blading, an inkjet printing, a screen printing, a spray method, a roll coating, or the like, but is not limited thereto.

In addition to such a method, the organic light emitting device can be manufactured by sequentially depositing from the cathode material to the organic material layer and the anode material on a substrate (WO 2003/012890).

Meanwhile, the organic light emitting device according to the present disclosure may be a bottom emission device, a top emission device, or a double-sided light emitting device, and particularly, may be a bottom emission device that requires relatively high luminous efficiency.

Below, preferable embodiments are presented to assist in the understanding of the present disclosure. The following examples are only provided for a better understanding of the present disclosure, and is not intended to limit the content of the present disclosure.

### Synthesis Example: Preparation of Intermediate Compounds P-1 to P-9

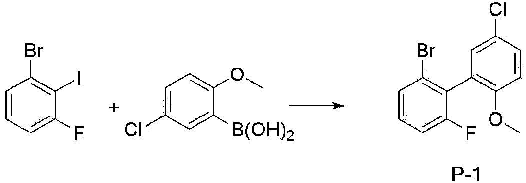

1-Bromo-3-fluoro-2-iodobenzene (100 g, 333.5 mmol) and (5-chloro-2-methoxyphenyl)boronic acid (62.2 g, 333.5 mmol) were dissolved in 800 ml of tetrahydrofuran (THF). Sodium carbonate (Na₂CO₃) 2M solution (500 mL) and tetrakis(triphenylphosphine)palladium(0) [Pd(PPh₃)₄] (7.7 g, 6.7 mmol) were added thereto, and the mixture was refluxed for 12 hours. After the reaction was completed, the mixture was cooled to room temperature, and the resulting mixture was extracted with water and toluene three times. The toluene layer was separated, dried over magnesium sulfate, filtered, and the filtrate was distilled under reduced pressure. The resulting mixture was recrystallized three times using chloroform and ethanol to give Compound P-1 (53.7 g, yield: 51%).

MS: [M+H]⁺ = 314

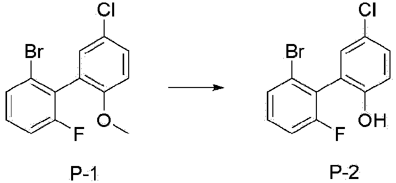

Compound P-1 (50.0 g, 158.5 mmol) was dissolved in dichloromethane (600 ml) and then cooled at 0°C. Boron tribromide (15.8 ml, 166.4 mmol) was slowly added dropwise and then stirred for 12 hours. After the reaction was completed, the mixture was washed with water three times, dried over magnesium sulfate, filtered, and the filtrate was distilled under reduced pressure and purified by column chromatography to give Compound P-2 (47.4 g, yield: 99%).

MS: [M+H]⁺ = 300

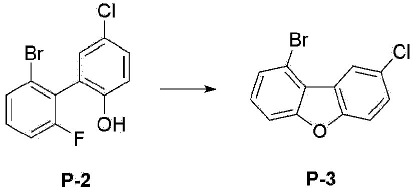

Compound P-2 (40.0 g, 132.7 mmol) was dissolved in distilled dimethylformamide (DMF) (400ml). The solution was cooled to 0°C, and sodium hydride (3.5 g, 145.9 mmol) was slowly added dropwise thereto. The mixture was stirred for 20 minutes, and then stirred at 100°C for 1 hour. After the reaction was completed, the mixture was cooled to room temperature, and 100 ml of ethanol was slowly added thereto. The above mixture was distilled under reduced pressure, and the resulting mixture was recrystallized from chloroform and ethyl acetate to give Compound P-3 (30.3 g, yield: 81%).

MS: [M+H]⁺ = 280

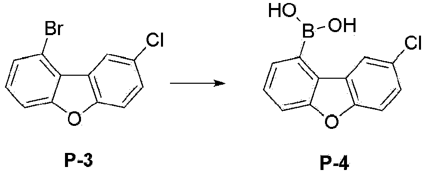

Compound P-3 (30.0 g, 106.6 mmol) was dissolved in tetrahydrofuran (300 ml), the temperature was lowered to -78°C, and 1.7 M tert-butyllithium (t-BuLi) (62.7 ml, 106.6 mmol) was slowly added thereto. After stirring for 1 hour at the same temperature, triisopropylborate (B(OiPr)₃) (28.3 ml, 213.1 mmol) was added thereto, and then stirred for 3 hours while gradually raising the temperature to room temperature. 2N aqueous hydrochloric acid solution (200 ml) was added to the reaction mixture, and stirred at room temperature for 1.5 hours. The produced precipitate was filtered, washed sequentially with water and ethyl ether, and then dried under vacuum. After drying, it was dispersed in ethyl ether, stirred for 2 hours, then filtered and dried to give Compound P-4 (24.4 g, yield: 93%).

MS: [M+H]⁺ = 247

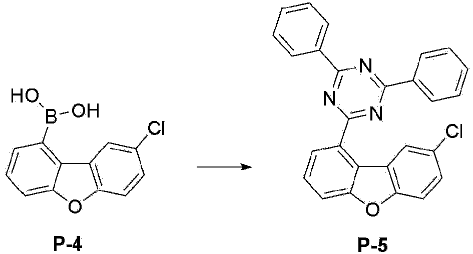

After Compound P-4 (20.0 g, 81.2 mmol) and 2-chloro-4,6-diphenyl-1,3,5-triazine (21.8 g, 81.2 mmol) were dispersed in tetrahydrofuran (250 ml), 2M potassium carbonate aqueous solution (aq. K₂CO₃) (33.6 ml, 243.5 mmol) and tetrakis(triphenylphosphine)palladium[Pd(PPh₃)₄] (1.9 g, 2 mol%) were added thereto, and the mixture was stirred and refluxed for 4 hours. The temperature was lowered to room temperature, and the produced solid was filtered. The filtered solid was recrystallized from tetrahydrofuran and ethyl acetate, filtered, and then dried to give Compound P-5 (32.4 g, yield: 92%).

MS: [M+H]⁺ = 434

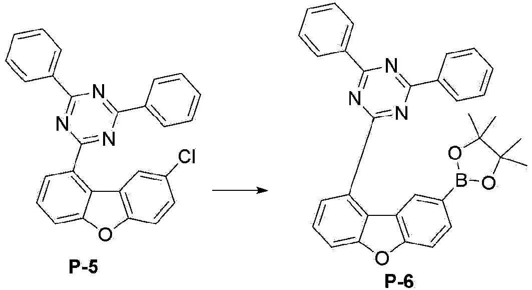

Compound P-5 (30 g, 69.2 mmol), bis(pinacolato)diborone) (19.3 g, 76.1 mmol), potassium acetate) (20.4 g, 207.5 mmol) and tetrakis(triphenylphosphine)palladium(0) [Pd(PPh₃)₄] (1.6 g, 2 mol%) were added to tetrahydrofuran (300 ml), and the mixture was refluxed for 12 hours. After the reaction was completed, the mixture was cooled to room temperature, and distilled under reduced pressure to remove the solvent. This was dissolved in chloroform, washed with water three times, and then the organic layer was separated and dried with magnesium sulfate. This was distilled under reduced pressure to give Compound P-6 (34.5 g, yield: 95%).

MS: [M+H]⁺ = 526

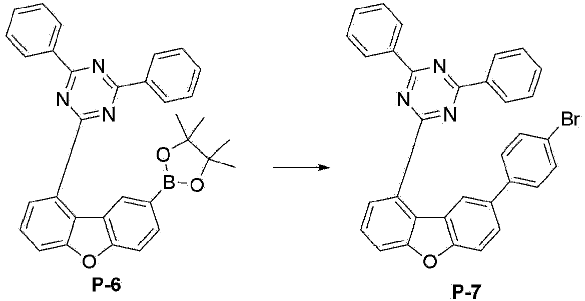

After Compound P-6 (30.0 g, 57.1 mmol) and 4-iodo-1-bromobenzene (16.2 g, 57.1 mmol) were dispersed in tetrahydrofuran (300 ml), 2M potassium carbonate aqueous solution (aq. K₂CO₃) (34 ml, 171 mmol) and tetrakis(triphenylphosphine)palladium[Pd(PPh₃)₄] (0.7 g, 1 mol%) were added thereto, and the mixture was stirred and refluxed for 12 hours. The temperature was lowered to room temperature, and the produced solid was filtered. The filtered solid was recrystallized from tetrahydrofuran and ethyl acetate, filtered, and then dried to give Compound P-7 (22.8 g, yield: 72%).

MS: [M+H]⁺ = 555

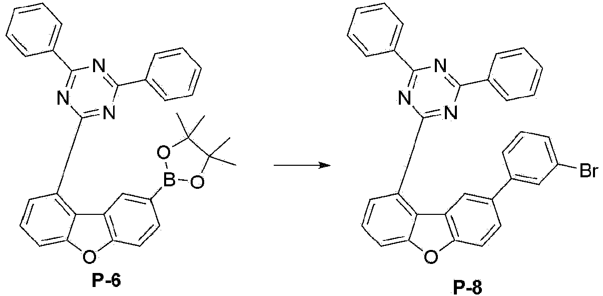

After Compound P-6 (30.0 g, 57.1 mmol) and 3-iodo-1-bromobenzene (16.2 g, 57.1 mmol) were dispersed in tetrahydrofuran (300 ml), 2M potassium carbonate aqueous solution (aq. K₂CO₃) (34 ml, 171 mmol) and tetrakis(triphenylphosphine)palladium[Pd(PPh₃)₄] (0.7 g, 1 mol%) were added thereto, and the mixture was stirred and refluxed for 12 hours. The temperature was lowered to room temperature, and the produced solid was filtered. The filtered solid was recrystallized from tetrahydrofuran and ethyl acetate, filtered, and then dried to give Compound P-8 (21.5 g, yield: 68%).

MS: [M+H]⁺ = 555

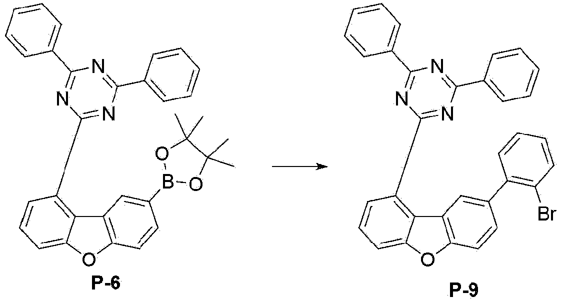

After Compound P-6 (30.0 g, 57.1 mmol) and 4-iodo-1-bromobenzene (16.2 g, 57.1 mmol) were dispersed in tetrahydrofuran (300 ml), 2M potassium carbonate aqueous solution (aq. K₂CO₃) (34 ml, 171 mmol) and tetrakis(triphenylphosphine)palladium[Pd(PPh₃)₄] (0.7 g, 1 mol%) were added thereto, and the mixture was stirred and refluxed for 12 hours. The temperature was lowered to room temperature, and the produced solid was filtered. The filtered solid was recrystallized from tetrahydrofuran and ethyl acetate, filtered, and then dried to give Compound P-9 (13.3 g, yield: 42%).

MS: [M+H]⁺ = 555

### [Preparation Example 1: Preparation of Compounds 1-1 to 1-8]

### Preparation Example 1-1: Preparation of Compound 1-1

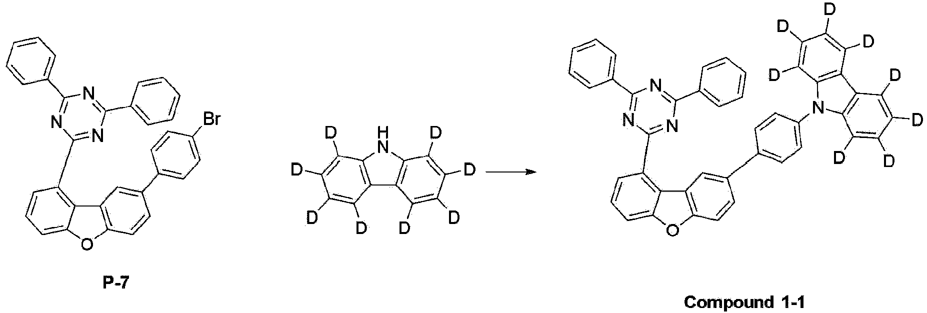

P-7 (20 g, 36.1 mmol) and 9H-carbazole-1,2,3,4,5,6,7,8-d8 (6.3 g, 36.1mmol) were added to 400 ml of tetrahydrofuran under a nitrogen atmosphere, and the mixture was stirred and refluxed. Then, potassium carbonate (15 g, 108.2 mmol) was dissolved in 15 ml of water and added thereto, and the mixture was sufficiently stirred, and then tetrakis(triphenylphosphine)palladium (1.2 g, 1.1 mmol) was added thereto. After the reaction for 3 hours, the reaction mixture was cooled to room temperature, and then the produced solid was filtered. The solid was added to 1170 mL of chloroform, dissolved, washed twice with water, and the organic layer was separated, to which anhydrous magnesium sulfate was added, stirred, then filtered, and the filtrate was distilled under reduced pressure. The concentrated compound was recrystallized from chloroform and ethyl acetate to give Compound 1-1 as a yellowish white solid (14 g, yield: 60%).

MS: [M+H]⁺ = 649.8

### Preparation Example 1-2: Preparation of Compound 1-2

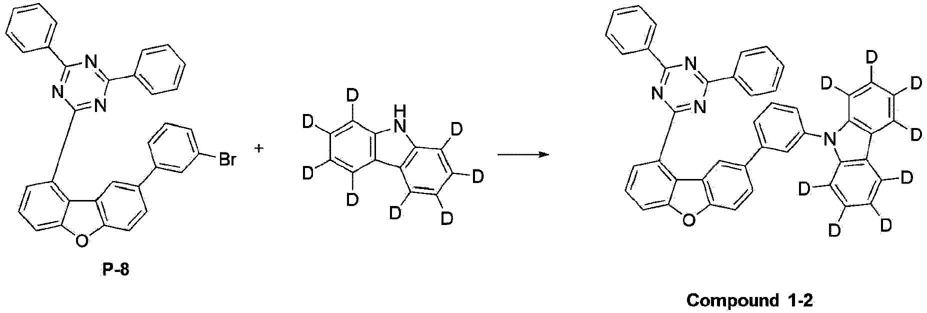

P-8 (20 g, 36.1 mmol) and 9H-carbazole-1,2,3,4,5,6,7,8-d8 (6.3 g, 36.1mmol) were added to 400 ml of tetrahydrofuran under a nitrogen atmosphere, and the mixture was stirred and refluxed. Then, potassium carbonate (15 g, 108.2 mmol) was dissolved in 15 ml of water and added thereto, and the mixture was sufficiently stirred, and then tetrakis(triphenylphosphine)palladium (1.2 g, 1.1 mmol) was added thereto. After the reaction for 3 hours, the reaction mixture was cooled to room temperature, and then the produced solid was filtered. The solid was added to 1172 mL of chloroform, dissolved, washed twice with water, and then the organic layer was separated, to which anhydrous magnesium sulfate was added, stirred, then filtered, and the filtrate was distilled under reduced pressure. The concentrated compound was recrystallized from chloroform and ethyl acetate to give Compound 1-2 as a yellowish white solid (17.3 g, yield: 74%).

MS: [M+H]⁺ = 650.8

### Preparation Example 1-3: Preparation of Compound 1-3

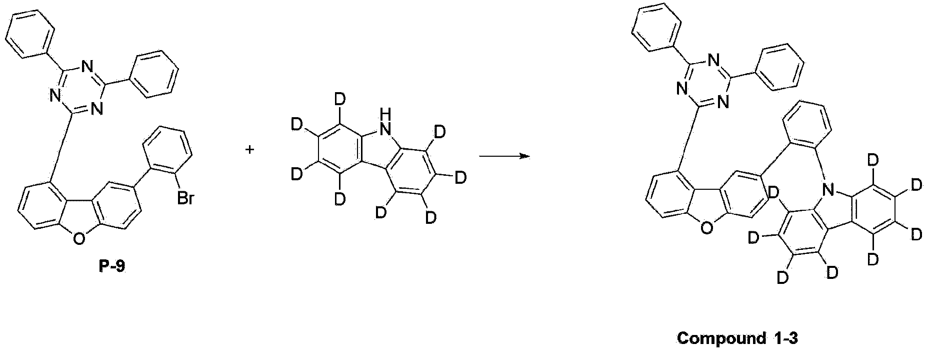

P-9 (20 g, 36.1 mmol) and 9H-carbazole-1,2,3,4,5,6,7,8-d8 (6.3 g, 36.1mmol) were added to 400 ml of tetrahydrofuran under a nitrogen atmosphere, and the mixture was stirred and refluxed. Then, potassium carbonate (15 g, 108.2 mmol) was dissolved in 15 ml of water and added thereto, and the mixture was sufficiently stirred, and then tetrakis(triphenylphosphine)palladium (1.2 g, 1.1 mmol) was added thereto. After the reaction for 1 hours, the reaction mixture was cooled to room temperature, and then the produced solid was filtered. The solid was added to 1172 mL of chloroform, dissolved, washed twice with water, and the organic layer was separated, to which anhydrous magnesium sulfate was added, stirred, then filtered, and the filtrate was distilled under reduced pressure. The concentrated compound was recrystallized from chloroform and ethyl acetate to give Compound 1-3 as a yellowish white solid (15.2 g, yield: 65%).

MS: [M+H]⁺ = 650.8

### Preparation Example 1-4: Preparation of Compound 1-4

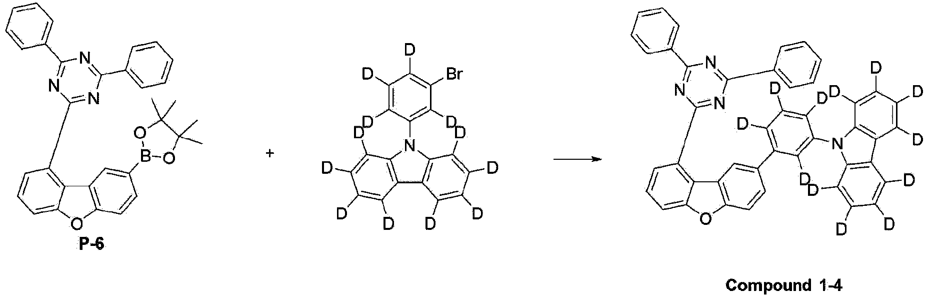

P-6 (20 g, 36.1 mmol) and 9-(3-bromo-phenyl-d4)-carbazole-1,2,3,4,5,6,7,8-d8 (6.2 g, 36.1 mmol) were added to 400 ml of tetrahydrofuran under a nitrogen atmosphere, and the mixture was stirred and refluxed. Then, potassium carbonate (15 g, 108.2 mmol) was dissolved in 15 ml of water and added thereto, and the mixture was sufficiently stirred, and then tetrakis(triphenylphosphine)palladium (1.2 g, 1.1 mmol) was added. After the reaction for 3 hours, the reaction mixture was cooled to room temperature, and then the produced solid was filtered. The solid was added to 1168 mL of chloroform, dissolved, washed twice with water, and the organic layer was separated, to which anhydrous magnesium sulfate was added, stirred, then filtered, and the filtrate was distilled under reduced pressure. The concentrated compound was recrystallized from chloroform and ethyl acetate to give Compound 1-4 as a white solid (16.8g, yield: 72%).

MS: [M+H]⁺ = 648.8

### Preparation Example 1-5: Preparation of Compound 1-5

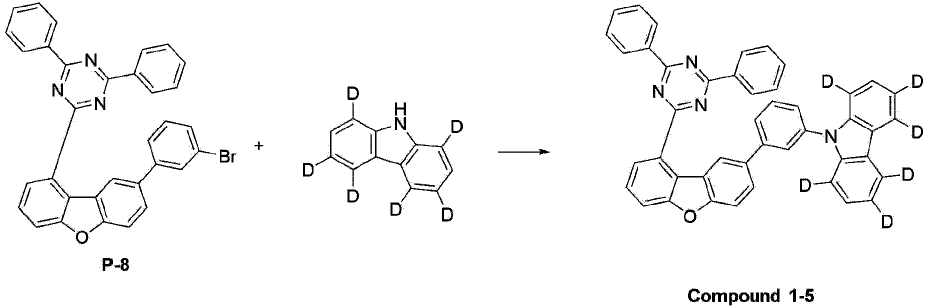

P-8 (20 g, 36.1 mmol) and 9H-carbazole-1,3,4,5,6,8-d6 (6.2 g, 36.1mmol) were added to 400 ml of tetrahydrofuran under a nitrogen atmosphere, and the mixture was stirred and refluxed. Then, potassium carbonate (15 g, 108.2 mmol) was dissolved in 15 ml of water and added thereto, and the mixture was sufficiently stirred, and then tetrakis(triphenylphosphine)palladium (1.2 g, 1.1 mmol) was added thereto. After the reaction for 2 hours, the reaction mixture was cooled to room temperature, and then the produced solid was filtered. The solid was added to 1168 mL of chloroform, dissolved, washed twice with water, and the organic layer was separated, to which anhydrous magnesium sulfate was added, stirred, then filtered, and the filtrate was distilled under reduced pressure. The concentrated compound was recrystallized from chloroform and ethyl acetate to give Compound 1-5 as a white solid (18g, yield: 77%).

MS: [M+H]⁺ = 648.8

### Preparation Example 1-6: Preparation of Compound 1-6

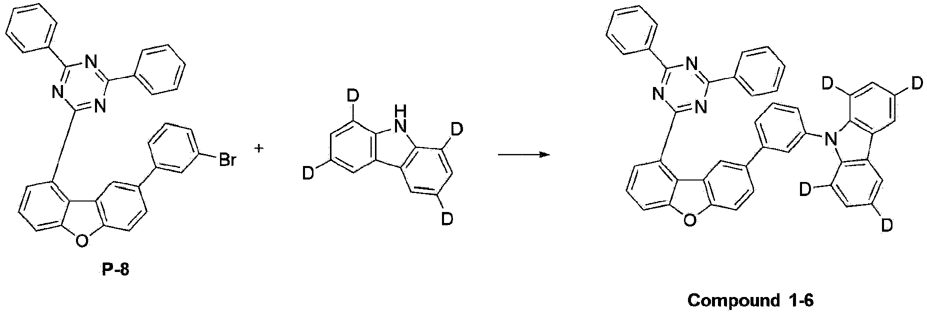

P-8 (20 g, 36.1 mmol) and 9H-carbazole-1,3,6,8-d4 (6.1 g, 36.1 mmol) were added to 400 ml of tetrahydrofuran under a nitrogen atmosphere, and the mixture was stirred and refluxed. Then, potassium carbonate (15 g, 108.2 mmol) was dissolved in 15 ml of water and added thereto, and the mixture was sufficiently stirred, and then tetrakis(triphenylphosphine)palladium (1.2 g, 1.1 mmol) was added thereto. After the reaction for 1 hours, the reaction mixture was cooled to room temperature, and then the produced solid was filtered. The solid was added to 1165 mL of chloroform, dissolved, washed twice with water, and the organic layer was separated, to which anhydrous magnesium sulfate was added, stirred, then filtered, and the filtrate was distilled under reduced pressure. The concentrated compound was recrystallized from chloroform and ethyl acetate to give Compound 1-6 as a white solid (16.5g, yield: 71%).

MS: [M+H]⁺ = 646.8

### Preparation Example 1-7: Preparation of Compound 1-7

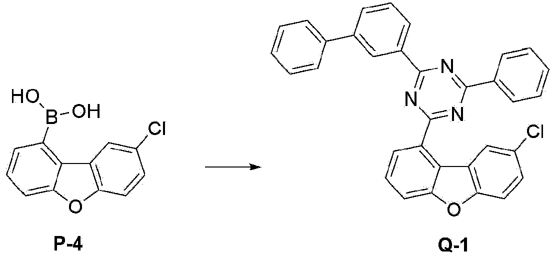

After Compound P-4 (20.0 g, 81.3 mmol) and 2-([1,1'-biphenyl]-3-yl)-4-chloro-6-phenyl-1,3,5-triazine (27.9 g, 81.2 mmol) were dispersed in tetrahydrofuran (250 ml), 2M potassium carbonate aqueous solution (aq. K₂CO₃) (33.6 ml, 243.5 mmol) and tetrakis(triphenylphosphine)palladium[Pd(PPh₃)₄] (1.9 g, 2 mol%) were added thereto, and the mixture was stirred and refluxed for 4 hours. The temperature was lowered to room temperature, and the produced solid was filtered. The filtered solid was recrystallized from tetrahydrofuran and ethyl acetate, filtered, and then dried to give Compound Q-1 (36.8 g, yield: 89 %).

MS: [M+H]⁺ = 510

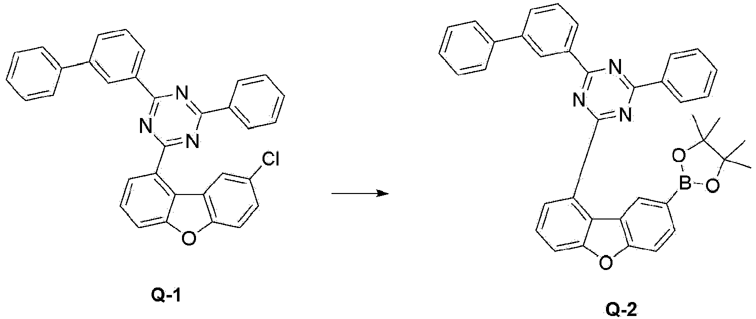

Compound Q-1 (30 g, 59 mmol), bis(pinacolato)diborone) (16.5 g, 65 mmol), potassium acetate (17 g, 177 mmol), dibenzylideneacetone palladium (1 g, 1.8 mmol) and tricyclohexylphosphine (1 g, 3.5 mmol) were added to dioxane (300 ml), and the mixture was refluxed for 12 hours. After the reaction was completed, the mixture was cooled to room temperature, and distilled under reduced pressure to remove the solvent. This was dissolved in chloroform, washed with water three times, and then the organic layer was separated and dried with magnesium sulfate. This was distilled under reduced pressure to give Compound Q-3 (32 g, yield: 90%).

MS: [M+H]⁺ = 602

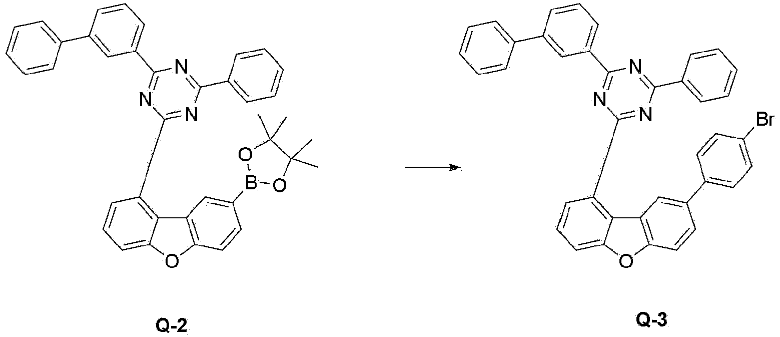

After Compound Q-2 (30.0 g, 49.8 mmol) and 4-iodo-1-bromobenzene (14.1 g, 57.1 mmol) were dispersed in tetrahydrofuran (300 ml), 2M potassium carbonate aqueous solution (aq. K₂CO₃) (30 ml, 150 mmol) and tetrakis(triphenylphosphine)palladium[Pd(PPh₃)₄] (0.6 g, 1 mol%) were added thereto, and the mixture was stirred and refluxed for 12 hours. The temperature was lowered to room temperature, and the produced solid was filtered. The filtered solid was recrystallized from tetrahydrofuran and ethyl acetate, filtered, and then dried to give Compound Q-3 (25.1 g, yield: 80 %).

MS: [M+H]⁺ = 630

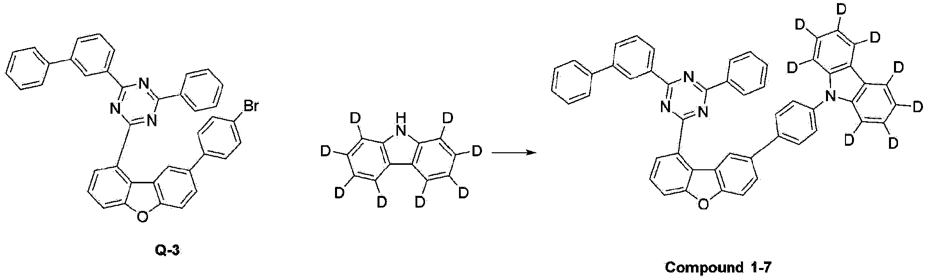

Q-3 (20 g, 31.7 mmol) and 9H-carbazole-1,2,3,4,5,6,7,8-d8 (8.1 g, 31.7mmol) were added to 400 ml of tetrahydrofuran under a nitrogen atmosphere, and the mixture was stirred and refluxed. Then, potassium carbonate (13.2 g, 95.2 mmol) was dissolved in 13 ml of water and added thereto, and the mixture was sufficiently stirred, and then tetrakis(triphenylphosphine)palladium (1.1 g, 1 mmol) was added thereto. After the reaction for 3 hours, the reaction mixture was cooled to room temperature, and then the produced solid was filtered. The solid was added to 1150 mL of chloroform, dissolved, washed twice with water, and the organic layer was separated, to which anhydrous magnesium sulfate was added, stirred, then filtered, and the filtrate was distilled under reduced pressure. The concentrated compound was recrystallized from chloroform and ethyl acetate to give Compound 1-7 as a yellowish white solid (17.7g, yield: 77%).

MS: [M+H]⁺ = 725.9

### Preparation Example 1-8: Preparation of Compound 1-8

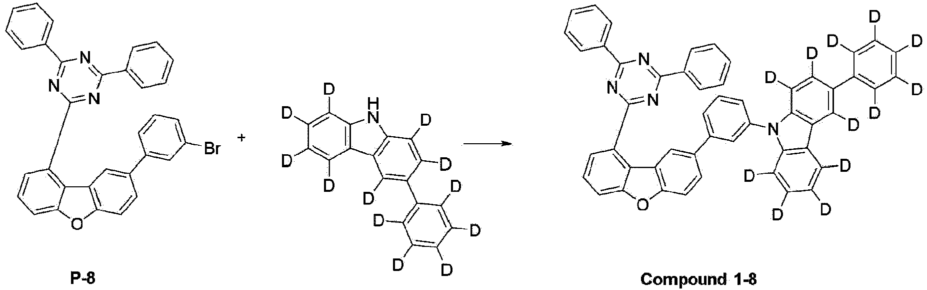

P-8 (20 g, 36.1 mmol) and 3-(phenyl-d5)-9H-carbazole-1,2,4,5,6,7,8-d7 (9.2 g, 36.1 mmol) were added to 400 ml of tetrahydrofuran under a nitrogen atmosphere, and the mixture was stirred and refluxed. Then, potassium carbonate (15 g, 108.2 mmol) was dissolved in 15 ml of water and added thereto, and the mixture was sufficiently stirred, and then tetrakis(triphenylphosphine)palladium (1.2 g, 1.1 mmol) was added thereto. After the reaction for 1 hours, the reaction mixture was cooled to room temperature, and then the produced solid was filtered. The solid was added to 1315 mL of chloroform, dissolved, washed twice with water, and then the organic layer was separated, to which anhydrous magnesium sulfate was added, stirred, then filtered, and the filtrate was distilled under reduced pressure. The concentrated compound was recrystallized from chloroform and ethyl acetate to give Compound 1-8 as a yellowish white solid (16.3g, 62%).

MS: [M+H]⁺ = 729.9

### [Preparation Example 2: Preparation of Compounds 2-1 to 2-3]

### Preparation Example 2-1: Preparation of Compound 2-1

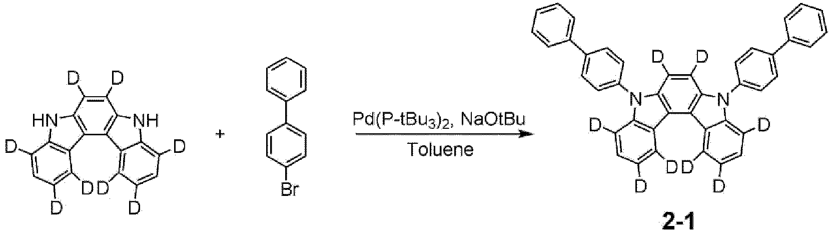

5,8-Dihydroindolo[2,3-c]carbazole-1,2,4,6,7,9,11,12-d8 (15.0 g, 56.7 mmol) and 4-bromo-1,1'-biphenyl (14.5 g, 62.4 mmol) were added to 300ml of toluene under a nitrogen atmosphere, and the mixture was stirred and refluxed. Then, sodium tert-butoxide (8.2 g, 85.1 mmol), and bis(tri-tert-butylphosphine)palladium(0) (0.9 g, 1.7 mmol) were added thereto. After the reaction for 10 hours, the reaction mixture was cooled to room temperature, the organic layer was separated using chloroform and water, and then the organic layer was distilled. This was again dissolved in chloroform, washed twice with water, and then the organic layer was separated, to which anhydrous magnesium sulfate was added, stirred, then filtered, and the filtrate was distilled under reduced pressure. The concentrated compound was purified by a silica gel column chromatography and then subjected to sublimation purification to give 11.9 g of Compound 2-1 (yield: 37%).

MS: [M+H]⁺ = 570

### Preparation Example 2-2: Preparation of Compound 2-2

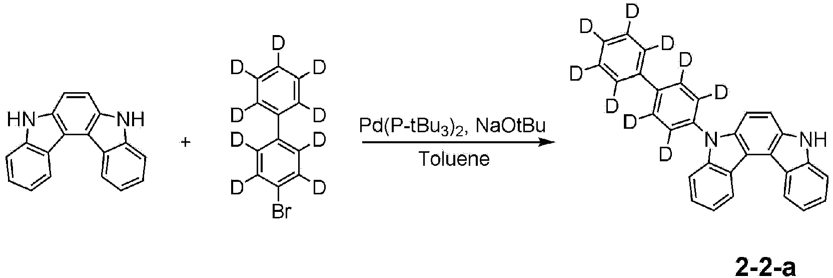

5,8-Dihydroindolo[2,3-c]carbazole (15.0 g, 58.5 mmol) and 4-bromo-1,1'-biphenyl-2,2',3,3',4',5,5',6,6'-d9 (15.6 g, 64.4 mmol) were added to 300 ml of toluene under a nitrogen atmosphere, and the mixture was stirred and refluxed. Then, sodium tert-butoxide (8.4 g, 87.8 mmol), and bis(tri-tert-butylphosphine)palladium(0) (0.9 g, 1.8 mmol) were added thereto. After the reaction for 11 hours, the reaction mixture was cooled to room temperature, the organic layer was separated using chloroform and water, and then the organic layer was distilled. This was again dissolved in chloroform, washed twice with water, and then the organic layer was separated, to which anhydrous magnesium sulfate was added, stirred, then filtered, and the filtrate was distilled under reduced pressure. The concentrated compound was purified by a silica gel column chromatography to give 17.6 g of Compound 2-2-a (yield: 72%).

MS: [M+H]⁺ = 419

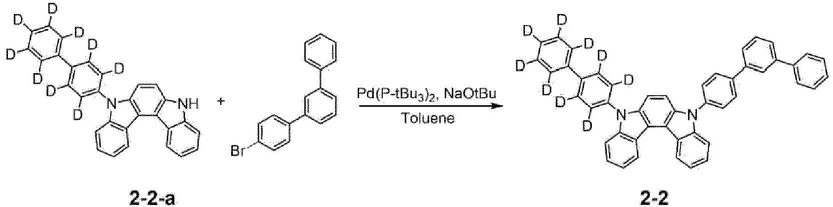

Compound 2-2-a (15.0 g, 35.9 mmol) and 4-bromo-1,1':3',1"-terphenyl (12.2 g, 39.5 mmol) were added to 300ml of toluene under a nitrogen atmosphere, and the mixture was stirred and refluxed. Then, sodium tert-butoxide (5.2 g, 53.9 mmol), and bis(tri-tert-butylphosphine)palladium(0)(0.6 g, 1.1 mmol) were added thereto. After the reaction for 7 hours, the reaction mixture was cooled to room temperature, the organic layer was separated using chloroform and water, and then the organic layer was distilled. This was again dissolved in chloroform, washed twice with water, and then the organic layer was separated, to which anhydrous magnesium sulfate was added, stirred, then filtered, and the filtrate was distilled under reduced pressure. The concentrated compound was purified by a silica gel column chromatography to give 9.3 g of Compound 2-2 (yield: 40%).

MS: [M+H]⁺ = 647

### Preparation Example 2-3: Preparation of Compound 2-3

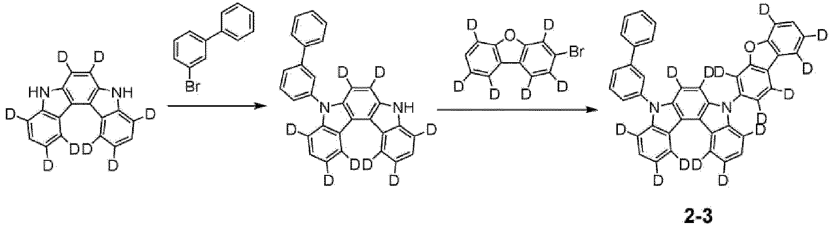

Compound 2-3 was prepared in the same manner as in the preparation method of Compound 2-2, except that in Preparation Example 2-2, 5,8-dihydroindolo[2,3-c]carbazole was changed to 5,8-dihydroindolo[2,3-c]carbazole-1,2,4,6,7,9,11,12-d8, 4-bromo-1,1'-biphenyl-2,2',3,3',4',5,5',6,6'-d9 was changed to 3-bromo-1,1'-biphenyl, and 4-bromo-1,1':3',1"-terphenyl was changed to 3-bromodibenzo[b,d]furan-1,2,4,6,8,9-d6.

MS: [M+H]+= 590

### [EXAMPLE]

### Example 1: Manufacture of organic light emitting device

A glass substrate on which a thin film of ITO (indium tin oxide) was coated in a thickness of 1400 Å was put into distilled water containing the detergent dissolved therein and washed by ultrasonic wave. At this time, the used detergent was a product commercially available from Fisher Co. and the distilled water was one which had been twice filtered by using a filter commercially available from Millipore Co. The ITO was cleaned for 30 minutes, and ultrasonic cleaning was then repeated twice for 10 minutes by using distilled water. After the cleaning with distilled water was completed, the substrate was ultrasonically washed with the solvents of isopropyl alcohol, acetone, and methanol, and dried, after which it was transported to a plasma cleaner. Then, the substrate was cleaned with oxygen plasma for 5 minutes, and then transferred to a vacuum evaporator.

On the ITO transparent electrode thus prepared, 95 wt.% of the following Compound HT-A and 5 wt.% of the following Compound PD were thermally vacuum-deposited to a thickness of 100 Å to form a hole injection layer, and then only Compound HT-A was deposited to a thickness of 1150 Å to form a hole transport layer. The following Compound HT-B was thermally vacuum-deposited thereon to a thickness of 450 Å as an electron blocking layer.

Then, Compound 1-1 prepared in Preparation Example 1-1 and Compound 2-1 prepared in Preparation Example 2-1 were used in a weight ratio of 4:6 as a host material, and the following Compound GD was used as a dopant material, wherein the host material and the dopant material were vacuum-deposited at a weight ratio of 92:8 to a thickness of 350 Å on the electron blocking layer to form a light emitting layer.

Then, the following Compound ET-A was vacuum-deposited to a thickness of 50 Å as a hole blocking layer. Then, the following Compound ET-B and Compound Liq were thermally vacuum-deposited at a weight ratio of 1:1 to a thickness of 300 Å as an electron transport layer, and then, Yb (ytterbium) was vacuum-deposited to a thickness of 10 Å as an electron injection layer.

Magnesium and silver were deposited in a weight ratio of 1: 4 to a thickness of 150 Å on the electron injection layer to form a cathode, thereby completing the manufacture of an organic light emitting device.

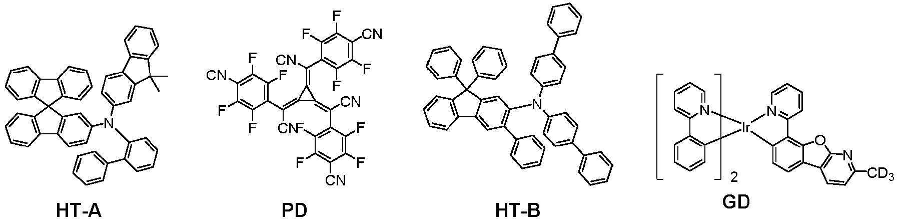

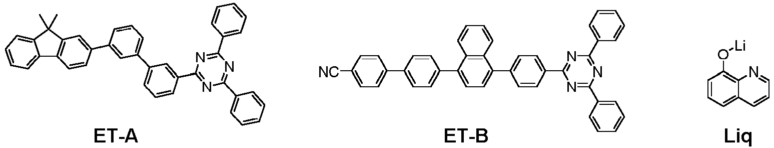

In the above-mentioned processes, the vapor deposition rate of the organic material was maintained at 0.4 ~ 0.7 A/sec, the deposition rate of magnesium and silver was maintained at 2 A/sec, and the degree of vacuum during the deposition was maintained at 2x10⁻⁷ ~ 5x10⁻⁶ torr, thereby manufacturing an organic light emitting device.

### Examples 2 to 10, and Comparative Examples 1 to 3

The organic light emitting devices of Examples 2 to 11 and Comparative Examples 1 to 3 were manufactured in the same manner as in Example 11, except that the host material was changed as shown in Table 1 below. Compound A-1 and Compound B-1 in Table 1 below are as follows.

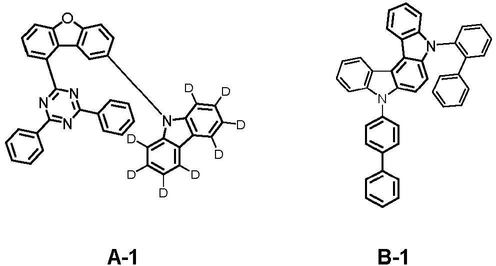

### [Experimental Example]

The organic light emitting devices manufactured in Examples 1 to 10 and Comparative Examples 1 to 3 were heat-treated in an oven at 120°C for 30 minutes, then taken out, and the voltage, efficiency, and lifetime (T95) were measured by applying a current, and the results are shown in Table 1 below. At this time, the driving voltage and efficiency were measured by applying a current density of 10 mA/cm², and T95 means the time (hr) required for the luminance to be reduced to 95% of the initial luminance at a current density of 20 mA/cm².

**[Table 1]**

| | Host material | | @ 10mA/cm² | | Color coordinate | @ 20mA/cm² |
|---|---|---|---|---|---|---|
| | First host | Second host | Voltage (V) | Efficiency (cd/A) | (x,y) | Lifetime (T95, hr) |
| Example 1 | Compound 1-1 | Compound 2-1 | 3.7 | 79.7 | 0.34, 0.62 | 163 |
| Example 2 | Compound 1-2 | Compound 2-1 | 3.8 | 80.4 | 0.34, 0.62 | 203 |
| Example 3 | Compound 1-3 | Compound 2-1 | 3.8 | 80.8 | 0.34, 0.62 | 172 |
| Example 4 | Compound 1-4 | Compound 2-1 | 3.8 | 80.4 | 0.34, 0.62 | 218 |
| Example 5 | Compound 1-5 | Compound 2-1 | 3.8 | 80.4 | 0.34, 0.62 | 192 |
| Example 6 | Compound 1-6 | Compound 2-1 | 3.8 | 80.4 | 0.34, 0.62 | 187 |
| Example 7 | Compound 1-7 | Compound 2-1 | 3.8 | 80.8 | 0.34, 0.62 | 215 |
| Example 8 | Compound 1-8 | Compound 2-1 | 3.7 | 81.6 | 0.34, 0.62 | 210 |
| Example 9 | Compound 1-2 | Compound 2-2 | 3.9 | 79.9 | 0.34, 0.62 | 186 |
| Example 10 | Compound 1-2 | Compound 2-3 | 3.8 | 78.9 | 0.34, 0.62 | 173 |
| Comparati ve Example 1 | Compound A-1 | Compound 2-1 | 4.1 | 77.5 | 0.34, 0.62 | 52 |
| Comparati ve Example 2 | Compound A-1 | Compound B-1 | 4.2 | 77.1 | 0.34, 0.62 | 75 |
| Comparati ve Example 3 | Compound 1-1 | Compound B-1 | 4.1 | 78.3 | 0.34, 0.62 | 90 |

It can be confirmed that when the compound represented by Chemical Formula 1 and the compound represented by Chemical Formula 2 were used as a light emitting layer host of an organic light emitting device, it exhibited low voltage, high efficiency, and long-life characteristics compared to materials having structures different from Chemical Formula 1 or Chemical Formula 2 in terms of structure and deuterium substitution rate.

### [Description of Symbols]

| | | | |
|---|---|---|---|
| 1: | substrate | 2: | anode |
| 3: | light emitting layer | 4: | cathode |
| 5: | hole injection layer | 6: | hole transport layer |
| 7: | electron blocking layer | 8: | hole blocking layer |
| 9: | electron transport layer | 10: | electron injection layer |

## Claims

1. An organic light emitting device comprising:
an anode (2);
a cathode (4); and
a light emitting layer (3) interposed between the anode (2) and the cathode (4),
wherein the light emitting layer (3) includes a compound represented by the following Chemical Formula 2-1,
wherein the light emitting layer (3) further includes a compound represented by the following Chemical Formula 1: 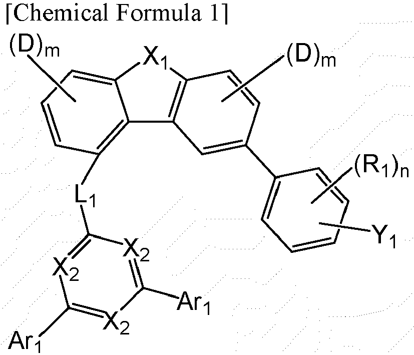
wherein, in Chemical Formula 1,
X₁ is O or S,
L₁ is a single bond,
each X₂ is independently N or CH, provided that at least one of X₂ is N,
each Ar₁ is independently a substituted or unsubstituted C₆₋₆₀ aryl, or a substituted or unsubstituted C₂₋₆₀ heteroaryl containing any one or more heteroatoms selected from the group consisting of N, O, and S,
each R₁ is independently hydrogen, deuterium, or a substituted or unsubstituted C₆₋₆₀ aryl,
Y₁ is the following group: 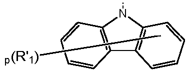 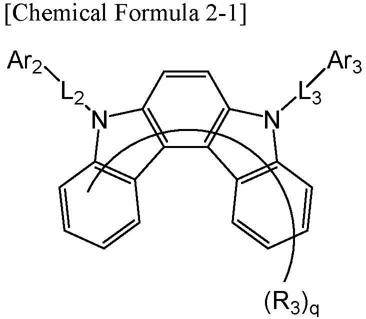
wherein, in Chemical Formula 2-1,
L₂ and L₃ are each independently a single bond, or a substituted or unsubstituted C₆₋₆₀ arylene,
Ar₂ and Ar₃ are each independently biphenylyl, terphenylyl, dibenzofuranyl, dibenzothiophenyl, or dimethylfluorenyl,
wherein the Ar₂ and Ar₃ are unsubstituted or substituted with at least one deuterium,
each R₃ is each independently hydrogen, deuterium, a substituted or unsubstituted C₆₋₆₀ aryl, or a substituted or unsubstituted C₂₋₆₀ heteroaryl containing any one or more heteroatoms selected from the group consisting of N, O, and S,
at least one of the L₂, L₃, Ar₂ and Ar₃ is substituted with at least one deuterium, or at least one of the R₃ is deuterium, and
q is an integer of 1 to 10,
**characterized in that** in the above group each R'1 is independently deuterium, or phenyl which is substituted with at least one deuterium, and
p is an integer of 1 to 10,
m is each independently an integer of 0 to 3, and
n is an integer of 0 to 4.

2. The organic light emitting device of claim 1, wherein:
X₂ is all N.

3. The organic light emitting device of claim 1, wherein:
each Ar₁ is independently phenyl which is unsubstituted or substituted with at least one deuterium, or biphenylyl which is unsubstituted or substituted with at least one deuterium.

4. The organic light emitting device of claim 1, wherein:
each R₁ is independently hydrogen, deuterium, or phenyl which is unsubstituted or substituted with at least one deuterium.

5. The organic light emitting device of claim 1, wherein:
the compound represented by Chemical Formula 1 is any one selected from the group consisting of:

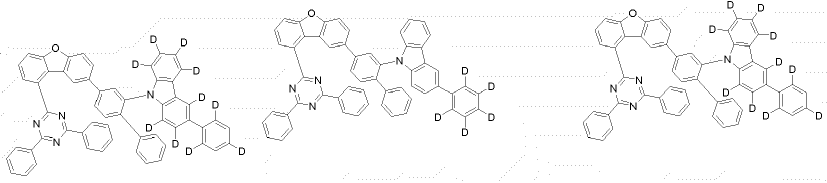

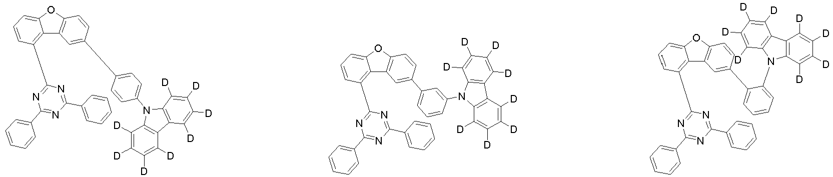

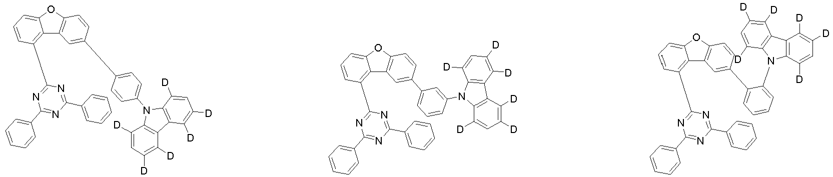

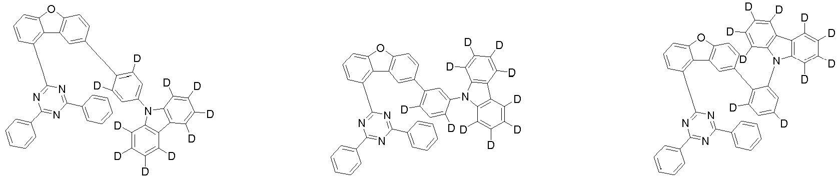

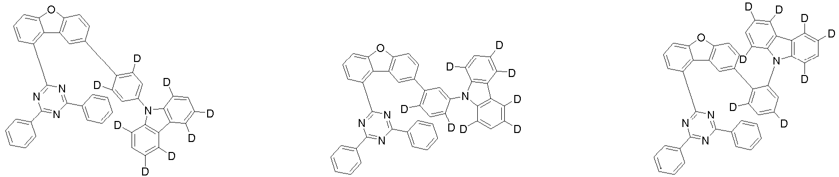

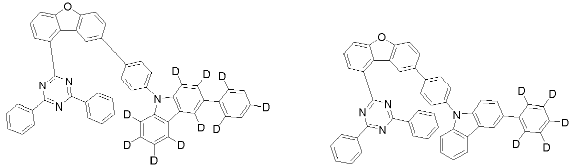

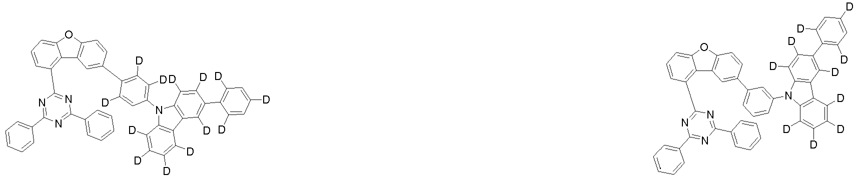

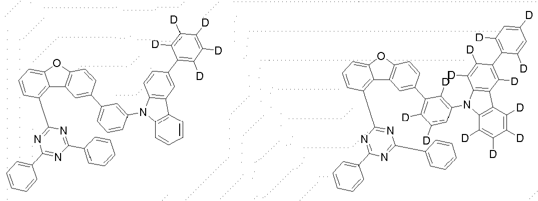

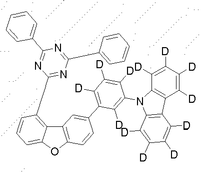

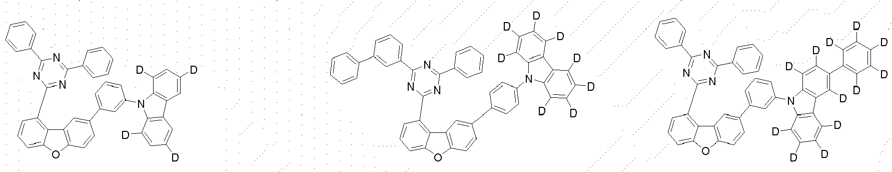

6. The organic light emitting device of claim 1, wherein:
L₂ and L₃ are each independently a single bond or phenylene,
wherein the phenylene is unsubstituted or substituted with at least one deuterium.

7. The organic light emitting device of claim 1, wherein:
each R₃ is independently hydrogen, or deuterium.

8. The organic light emitting device of claim 1, wherein:
the compound represented by Chemical Formula 2-1 is any one selected from the group consisting of: 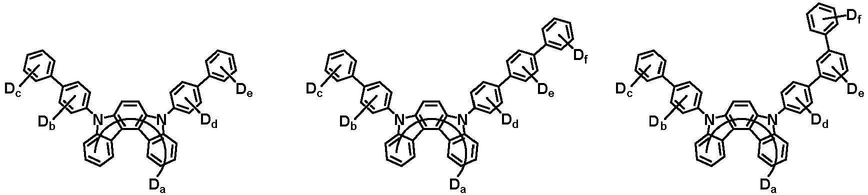 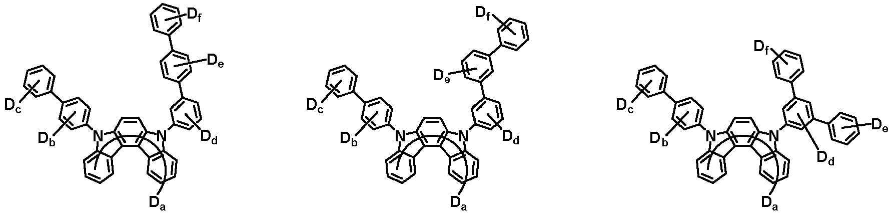 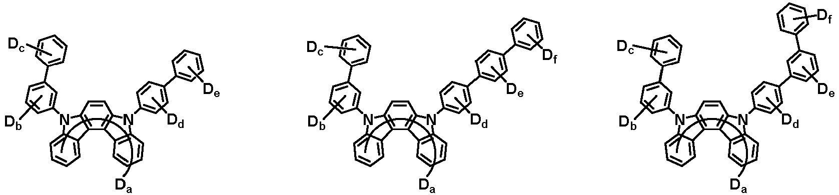 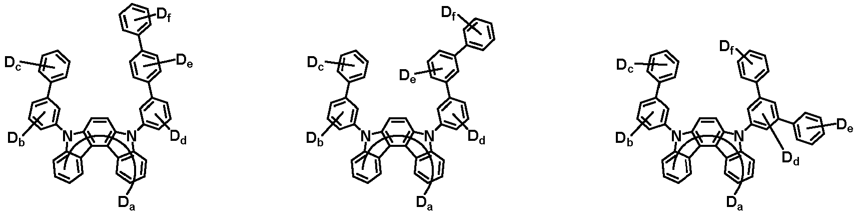 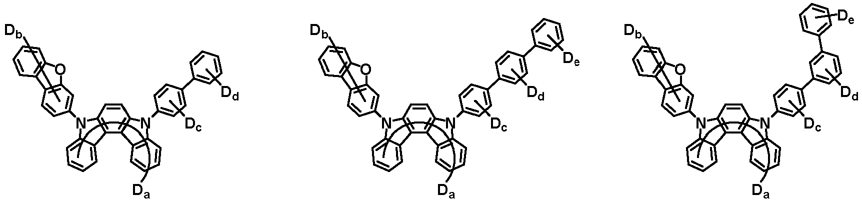 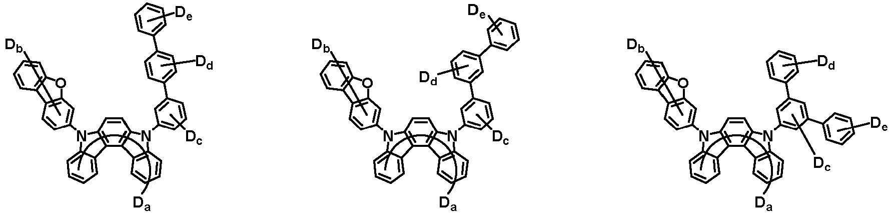 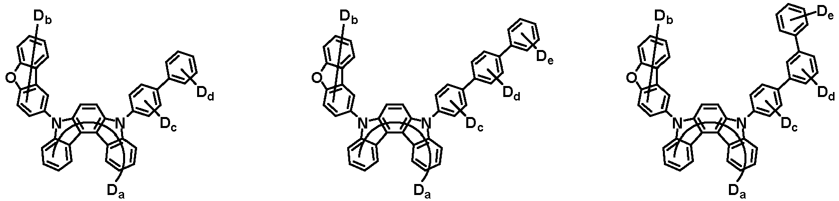 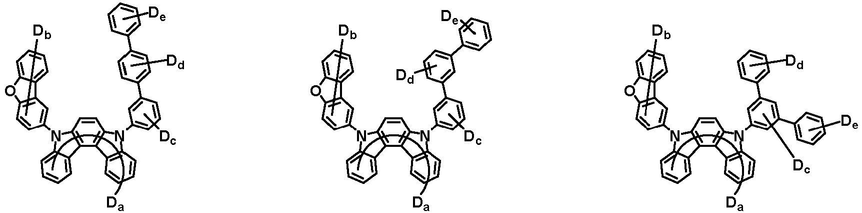 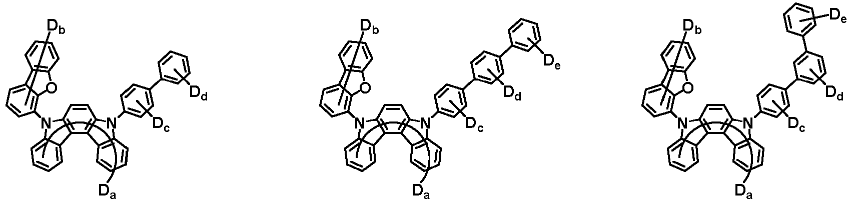 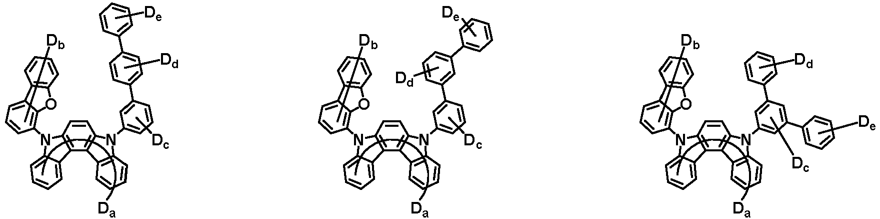 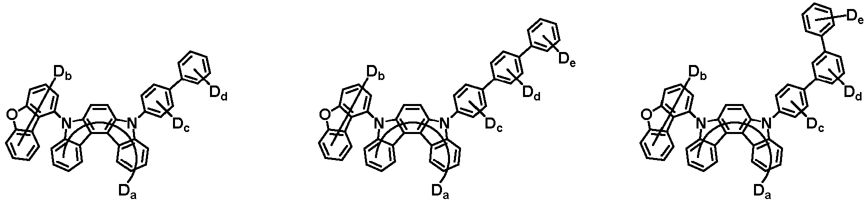 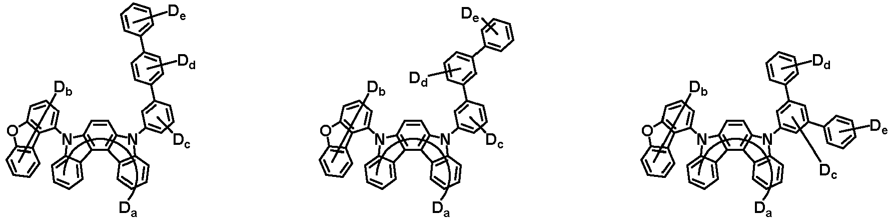 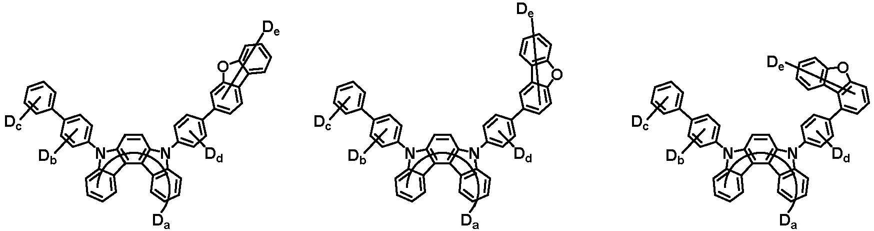 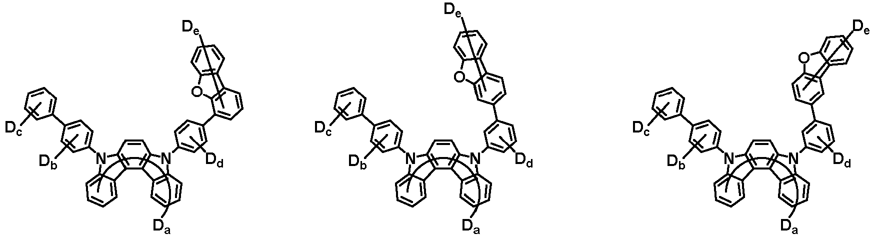 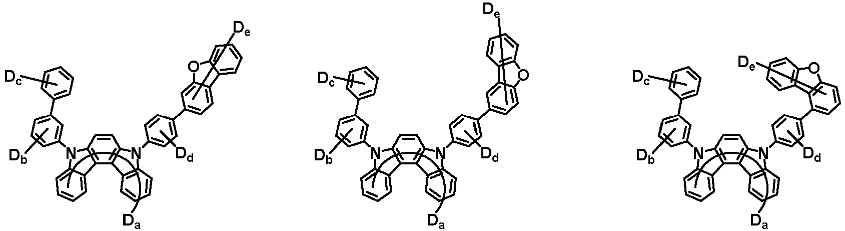 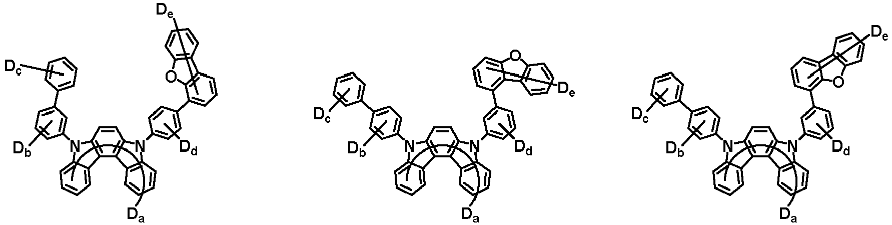 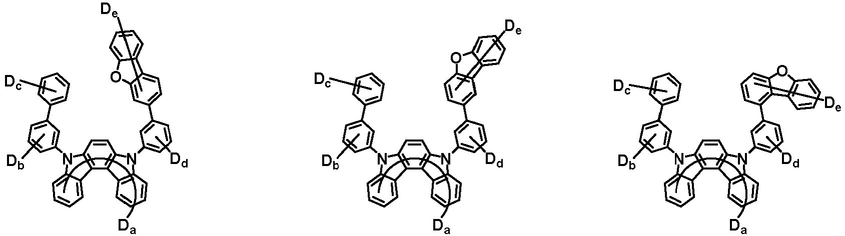 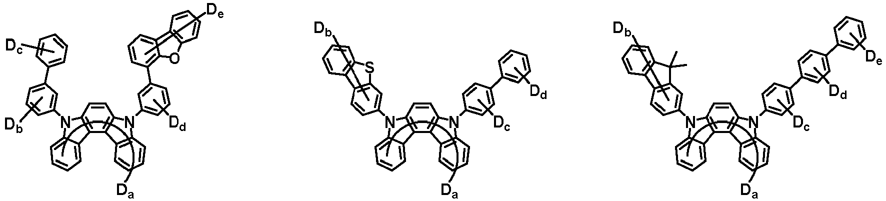 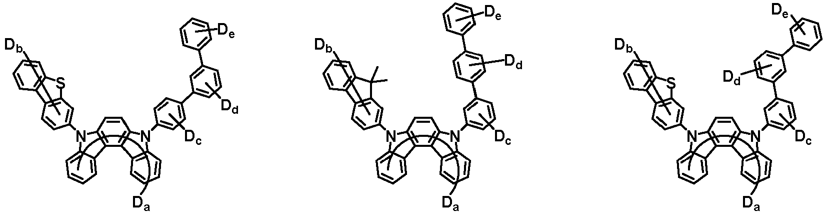 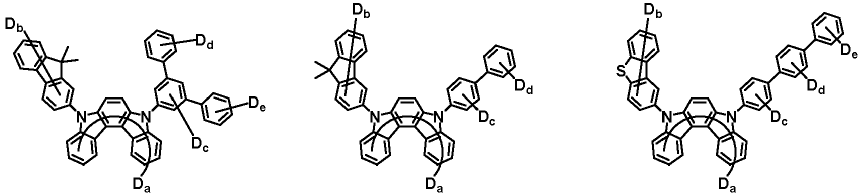 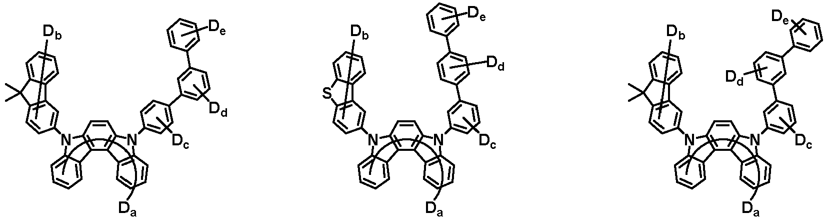 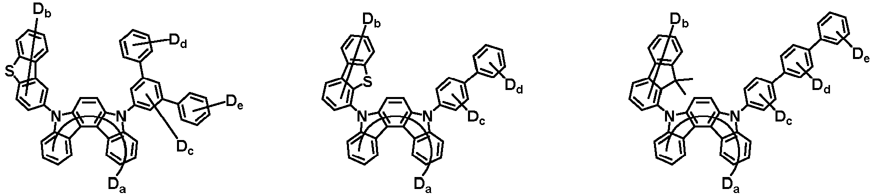 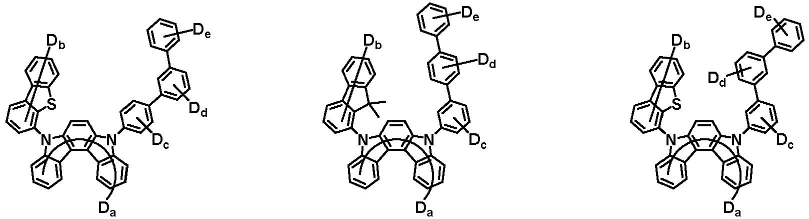 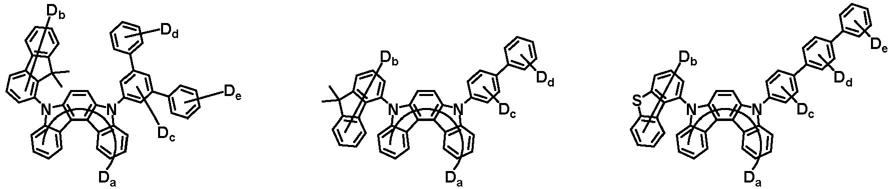 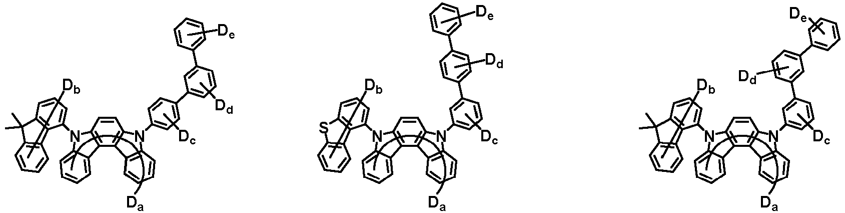 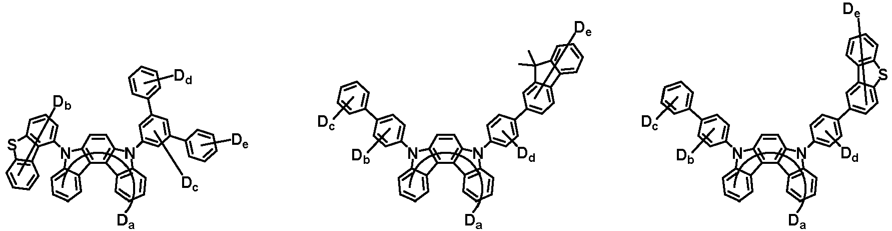 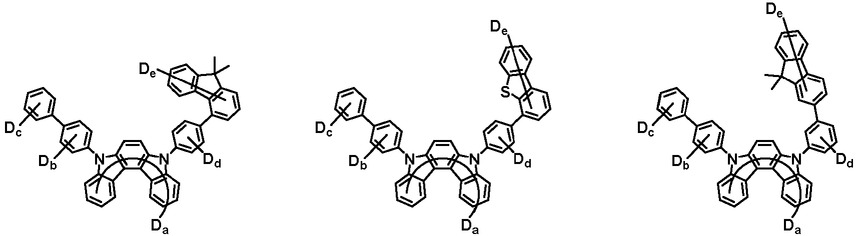 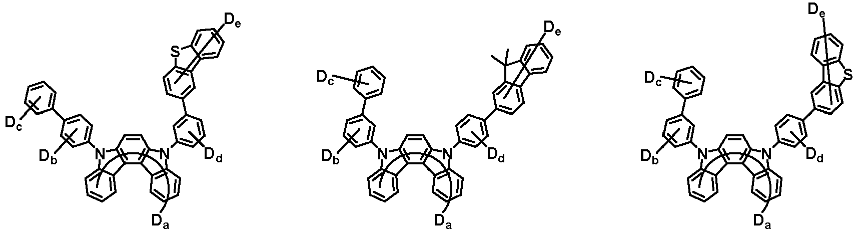 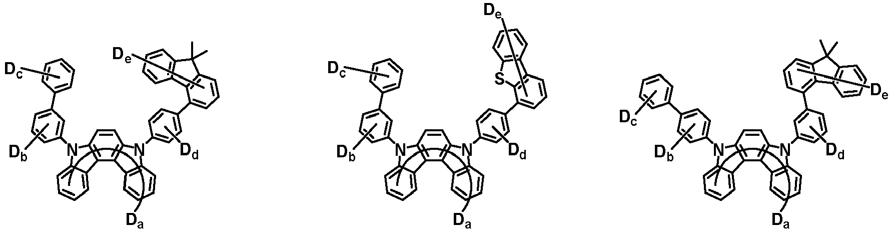 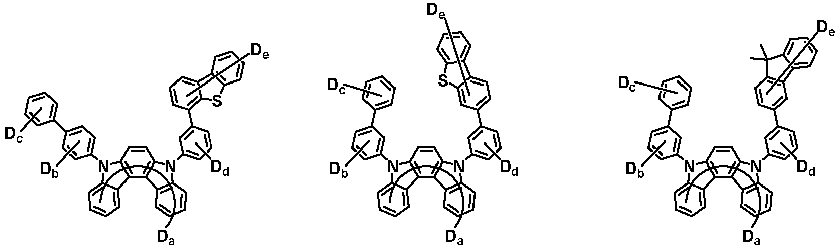 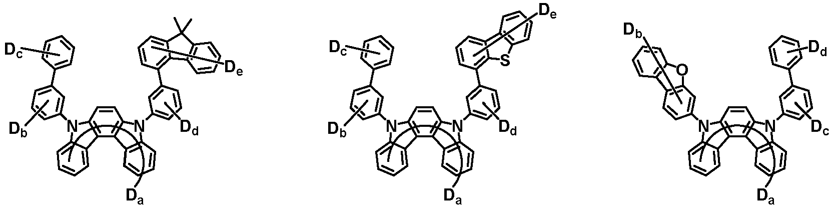
wherein, in the above group,
a is an integer of 0 to 10,
b is an integer of 0 to 7,
c is an integer of 0 to 5,
d is an integer of 0 to 5,
e is an integer of 0 to 7,
f is an integer of 0 to 5,
provided that the sum of a to f is 1 or more.

## Patentansprüche

1. Organische lichtemittierende Vorrichtung, umfassend:
eine Anode (2);
eine Kathode (4); und
eine zwischen der Anode (2) und der Kathode (4) angeordnete lichtemittierende Schicht (3),
wobei die lichtemittierende Schicht (3) eine Verbindung einschließt, dargestellt durch die folgende chemische Formel 2-1,
wobei die lichtemittierende Schicht (3) weiter eine Verbindung einschließt, dargestellt durch die folgende chemische Formel 1: 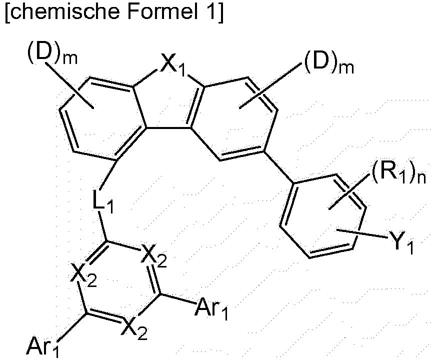
wobei, in der chemischen Formel 1,
X₁ O oder S ist,
L₁ eine Einfachbindung ist,
jedes X₂ jeweils unabhängig voneinander N oder CH ist, mit der Maßgabe, dass mindestens eines von X₂ N ist,
jedes Ar₁ jeweils unabhängig voneinander ein substituiertes oder unsubstituiertes C₆₋₆₀-Aryl oder ein substituiertes oder unsubstituiertes C₂₋₆₀-Heteroaryl ist, das ein oder mehrere Heteroatome enthält, ausgewählt aus der Gruppe bestehend aus N, O und S,
jedes R₁ jeweils unabhängig voneinander Wasserstoff, Deuterium oder ein substituiertes oder unsubstituiertes C₆₋₆₀-Aryl ist,
Y₁ die folgende Gruppe ist: 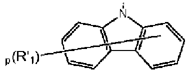 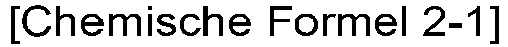 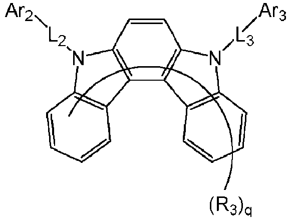
wobei, in der chemischen Formel 2-1,
L₂ und L₃ jeweils unabhängig voneinander eine Einfachbindung oder ein substituiertes oder unsubstituiertes C₆₋₆₀-Arylen sind,
Ar₂ und Ar₃ jeweils unabhängig voneinander Biphenylyl, Terphenylyl, Dibenzofuranyl, Dibenzothiophenyl oder Dimethylfluorenyl sind,
wobei Ar₂ und Ar₃ unsubstituiert oder mit mindestens einem Deuterium substituiert sind,
jedes R₃ jeweils unabhängig voneinander Wasserstoff, Deuterium, ein substituiertes oder unsubstituiertes C₆₋₆₀Aryl oder ein substituiertes oder unsubstituiertes C₂₋₆₀-Heteroaryl ist, das ein oder mehrere Heteroatome enthält, ausgewählt aus der Gruppe bestehend aus N, O und S,
mindestens eines von L₂, L₃, Ar₂ und Ar₃ mit mindestens einem Deuterium substituiert ist oder mindestens eines von R₃ Deuterium ist, und
q eine ganze Zahl von 1 bis 10 ist,
**dadurch gekennzeichnet, dass** in der obigen Gruppe jedes R'1 jeweils unabhängig voneinander Deuterium oder Phenyl ist, das mit mindestens einem Deuterium substituiert ist, und
p eine ganze Zahl von 1 bis 10 ist,
m jeweils unabhängig voneinander eine ganze Zahl von 0 bis 3 ist, und
n eine ganze Zahl von 0 bis 4 ist.

2. Organische lichtemittierende Vorrichtung nach Anspruch 1, wobei:
X₂ sämtlich N ist.

3. Organische lichtemittierende Vorrichtung nach Anspruch 1, wobei:
jedes Ar₁ jeweils unabhängig voneinander Phenyl ist, das unsubstituiert oder mit mindestens einem Deuterium substituiert ist, oder Biphenylyl ist, das unsubstituiert oder mit mindestens einem Deuterium substituiert ist.

4. Organische lichtemittierende Vorrichtung nach Anspruch 1, wobei:
jedes R₁ jeweils unabhängig voneinander Wasserstoff, Deuterium oder Phenyl ist, das unsubstituiert oder mit mindestens einem Deuterium substituiert ist.

5. Organische lichtemittierende Vorrichtung nach Anspruch 1, wobei:
die durch die chemische Formel 1 dargestellte Verbindung eine ist, ausgewählt aus der folgenden Gruppe bestehend aus:

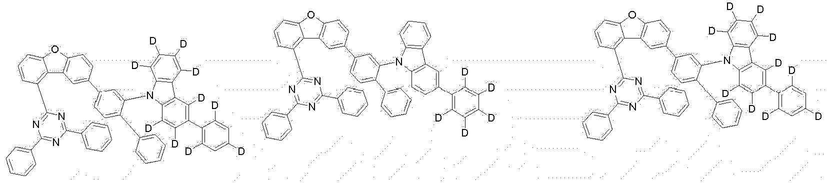

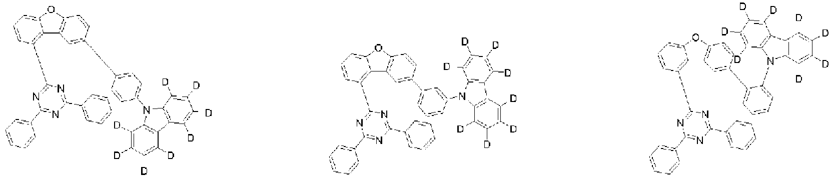

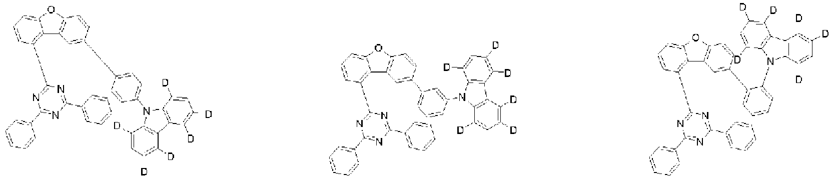

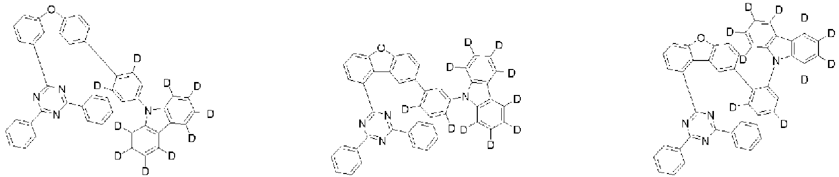

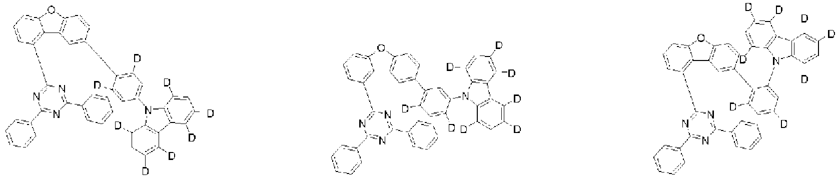

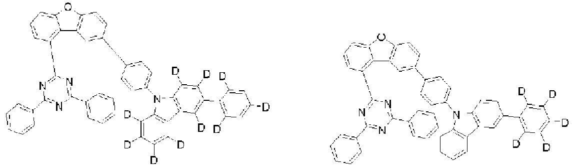

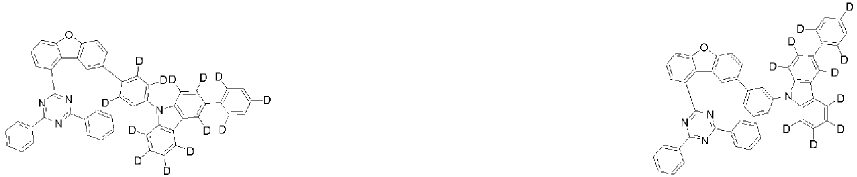

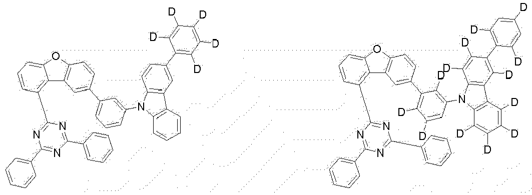

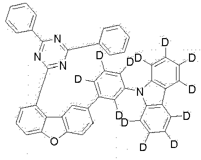

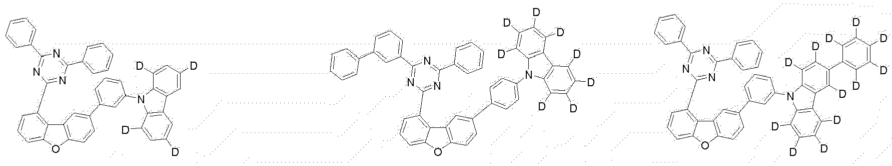

6. Organische lichtemittierende Vorrichtung nach Anspruch 1, wobei:
L₂ und L₃ jeweils unabhängig voneinander eine Einfachbindung oder Phenylen sind,
wobei das Phenylen unsubstituiert oder mit mindestens einem Deuterium substituiert ist.

7. Organische lichtemittierende Vorrichtung nach Anspruch 1, wobei:
jedes R₃ jeweils unabhängig voneinander Wasserstoff oder Deuterium ist.

8. Organische lichtemittierende Vorrichtung nach Anspruch 1, wobei:
die durch die chemische Formel 2-1 dargestellte Verbindung eine ist, ausgewählt aus der folgenden Gruppe bestehend aus: 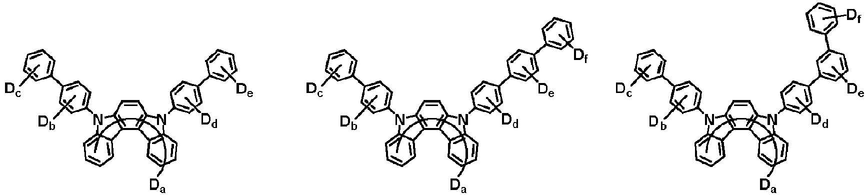 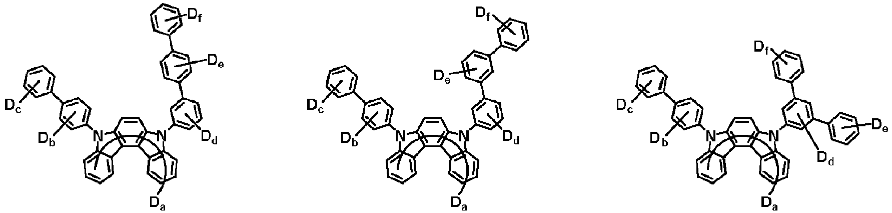 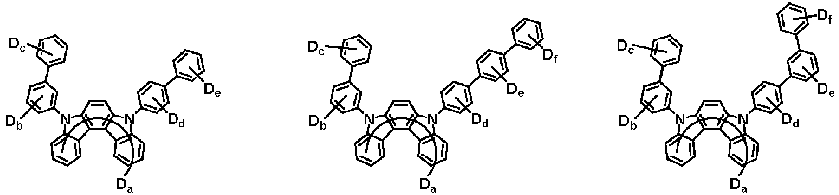 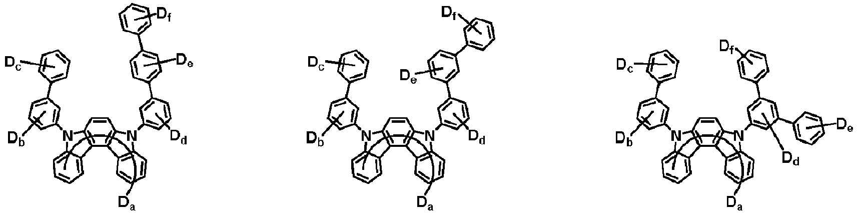 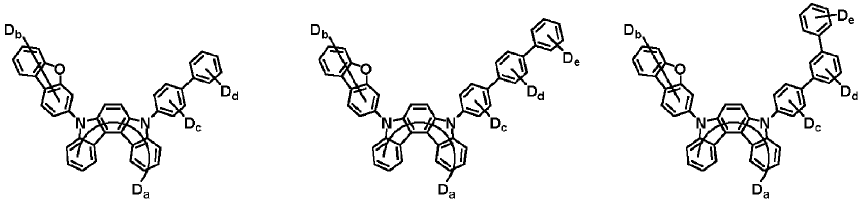 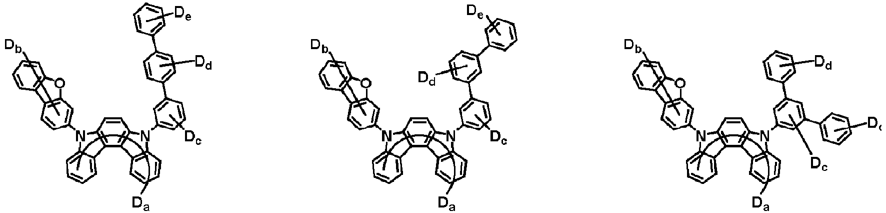 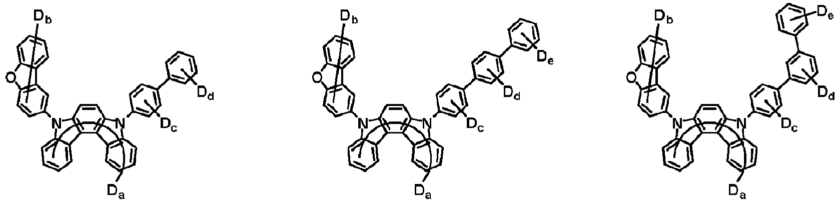 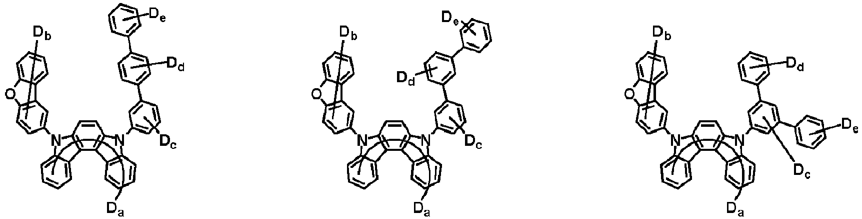 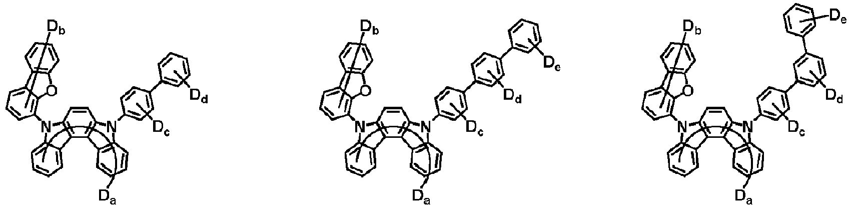 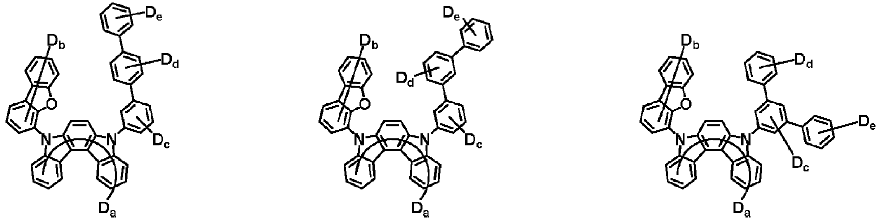 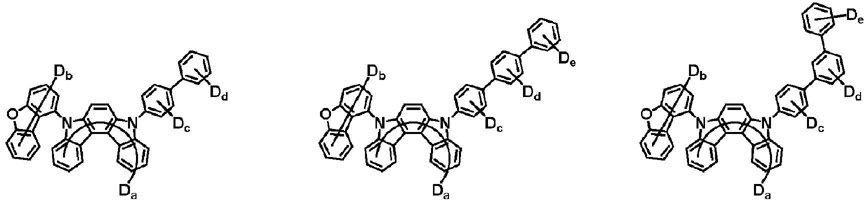 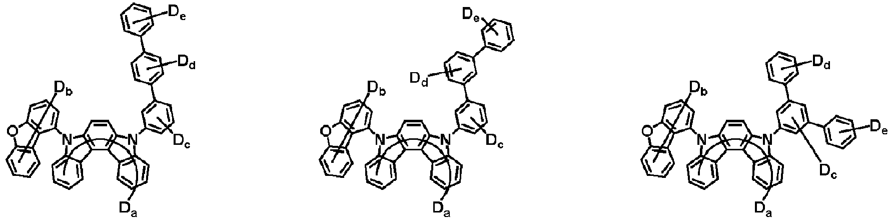 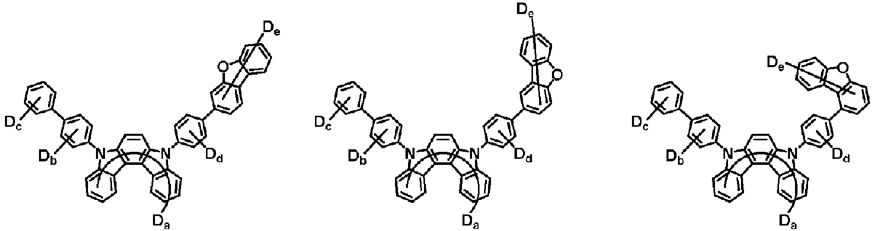 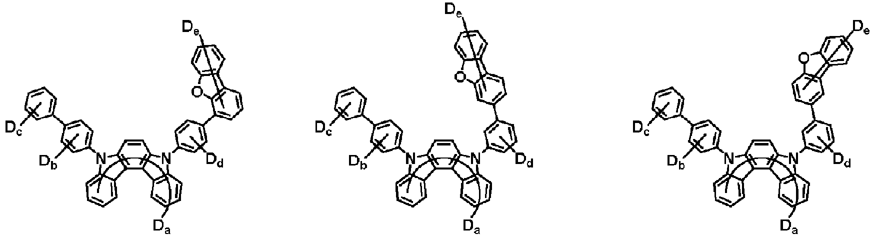 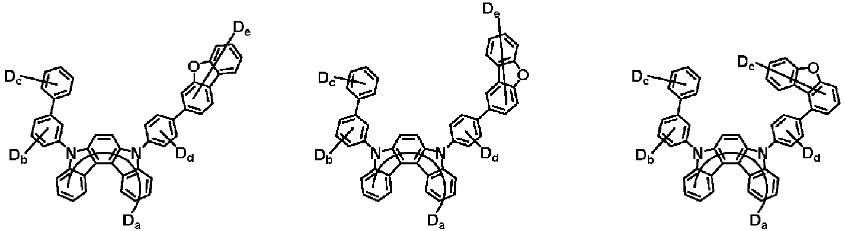 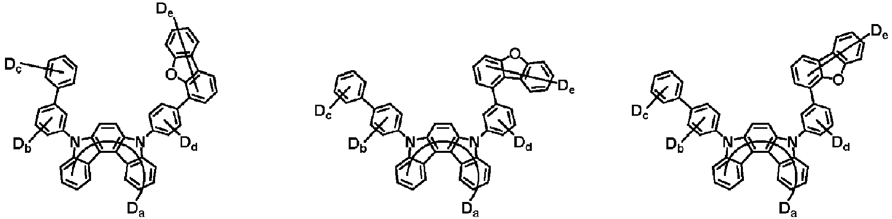 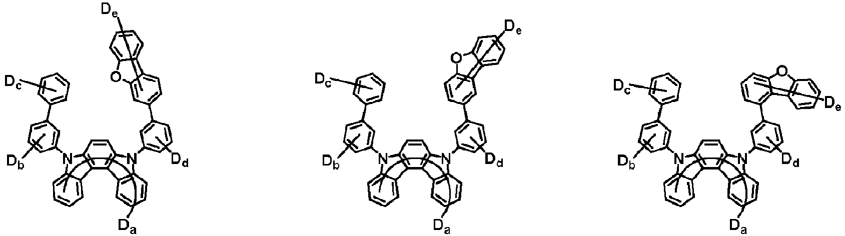 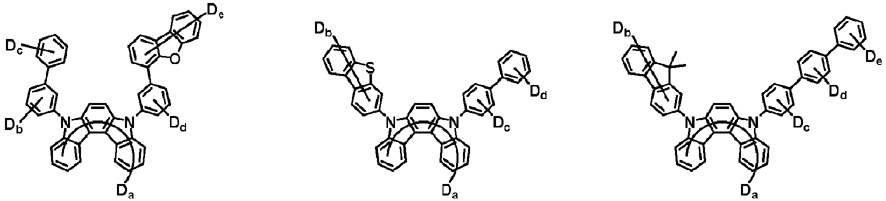 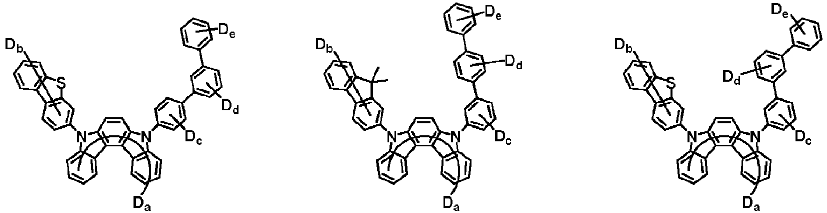 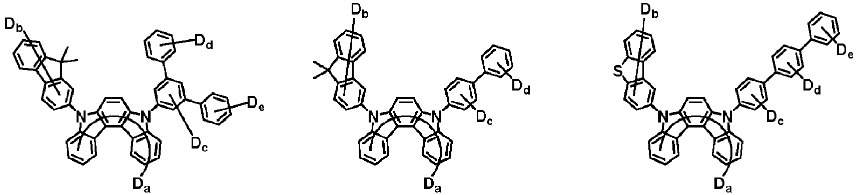 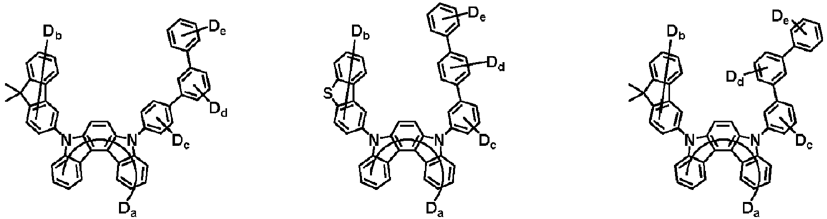 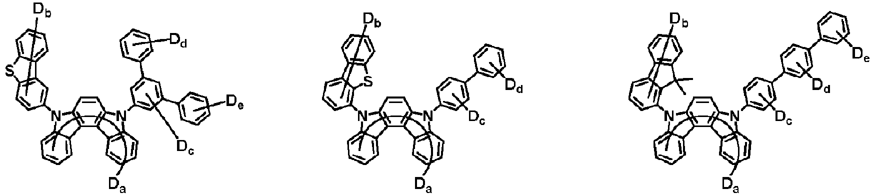 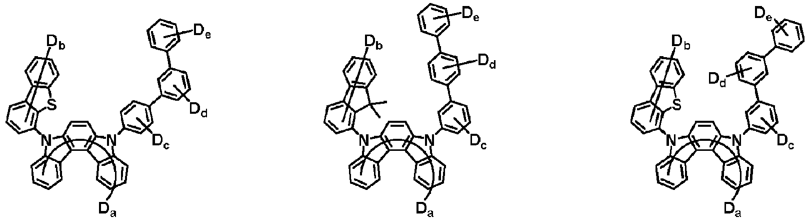 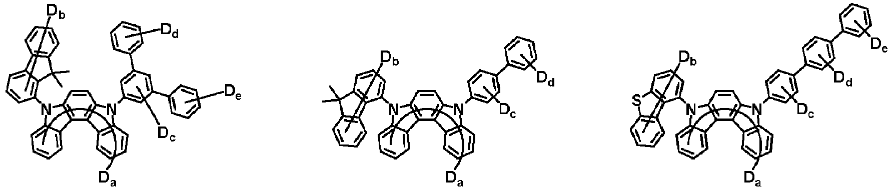 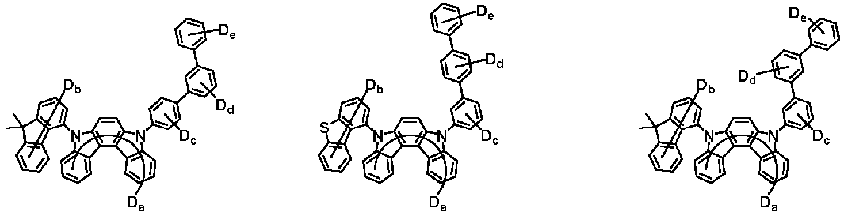 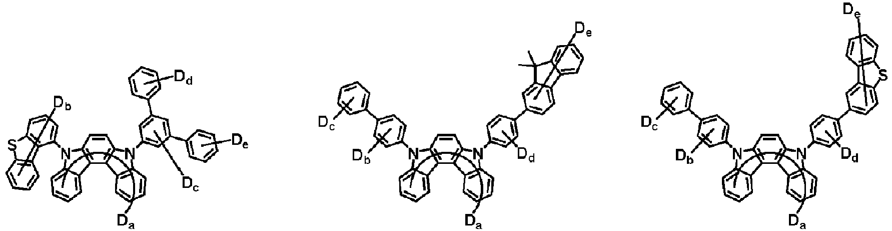 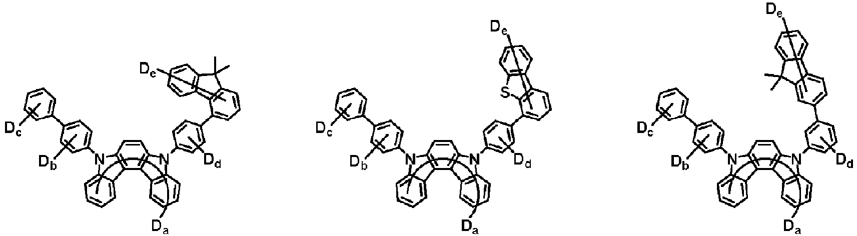 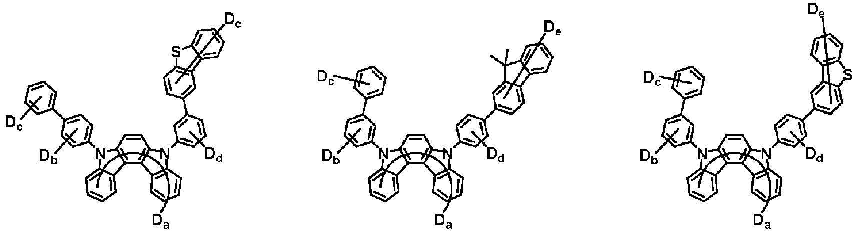 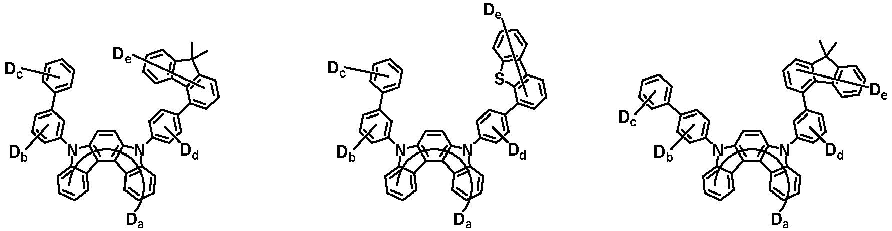 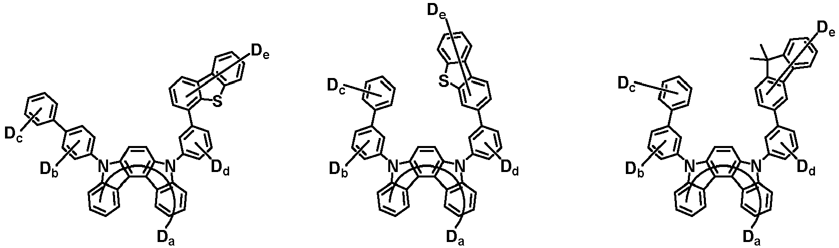 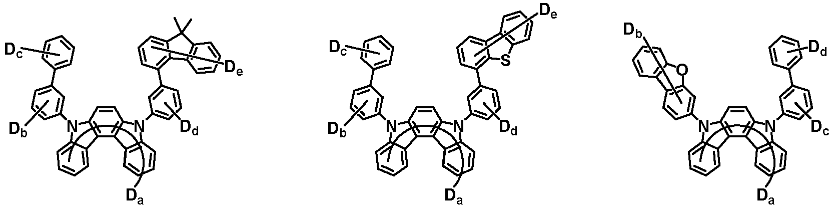
wobei, in der obigen Gruppe,
a eine ganze Zahl von 0 bis 10 ist,
b eine ganze Zahl von 0 bis 7 ist,
c eine ganze Zahl von 0 bis 5 ist,
d eine ganze Zahl von 0 bis 5 ist,
e eine ganze Zahl von 0 bis 7 ist,
f eine ganze Zahl von 0 bis 5 ist,
mit der Maßgabe, dass die Summe von a bis f 1 oder mehr ist.

## Revendications

1. Dispositif électroluminescent organique comprenant :
une anode (2) ;
une cathode (4) ; et
une couche électroluminescente (3) interposée entre l'anode (2) et la cathode (4),
dans lequel la couche électroluminescente (3) inclut un composé représenté par la formule chimique 2-1 suivante,
dans lequel la couche électroluminescente (3) inclut en outre un composé représenté par la formule chimique 1 suivante : 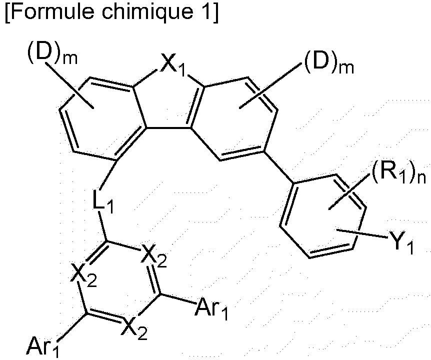
dans lequel, dans la formule chimique 1,
X₁ is O or S,
L₁ est une liaison simple,
chaque X₂ est indépendamment N ou CH, à condition qu'au moins un des X₂ soit N,
chaque Ar₁ est indépendamment un aryle en C₆₋₆₀ substitué ou non substitué, ou un hétéroaryle en C₂₋₆₀ substitué ou non substitué contenant un quelconque ou plusieurs hétéroatomes sélectionnés parmi le groupe consistant en N, O et S,
chaque R₁ est indépendamment hydrogène, deutérium, ou un aryle en C₆₋₆₀ substitué ou non substitué,
Y₁ est le groupe suivant : 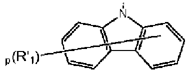 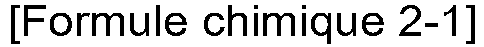 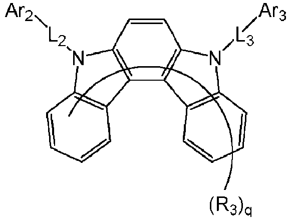
dans lequel, dans la formule chimique 2-1,
L₂ et L₃ sont chacun indépendamment une liaison simple, ou un arylène en C₆₋₆₀ substitué ou non substitué,
Ar₂ et Ar₃ sont chacun indépendamment biphénylyle, terphénylyle, dibenzofuranyle, dibenzothiophényle, ou diméthylfluorényle,
dans lequel Ar₂ et Ar₃ sont non substitués ou substitués par au moins un deutérium,
chaque R₃ est chacun indépendamment hydrogène, deutérium, un aryle en C₆₋₆₀ substitué ou non substitué, ou un hétéroaryle en C₂₋₆₀ substitué ou non substitué contenant un ou plusieurs hétéroatomes sélectionnés parmi le groupe constitué de N, O et S,
au moins un parmi L₂, L₃, Ar₂ et Ar₃ est substitué par au moins un deutérium, ou au moins un des R₃ est deutérium, et
q est un nombre entier de 1 à 10,
**caractérisé en ce que** dans le groupe ci-dessus chaque R'1 est indépendamment un deutérium, ou un phényle qui est substitué par au moins un deutérium, et
p est un nombre entier de 1 à 10,
chaque m est indépendamment un nombre entier de 0 à 3, et
n est un nombre entier de 0 à 4.

2. Dispositif électroluminescent organique selon la revendication 1, dans lequel
X₂ est, dans tous les cas, N.

3. Dispositif électroluminescent organique selon la revendication 1, dans lequel :
chaque Ar₁ est indépendamment un phényle qui est non substitué ou substitué par au moins un deutérium, ou un biphénylyle qui est non substitué ou substitué par au moins un deutérium.

4. Dispositif électroluminescent organique selon la revendication 1, dans lequel :
chaque R₄ est indépendamment un hydrogène, deutérium, ou phényle qui est non substitué ou substitué par au moins un deutérium.

5. Dispositif électroluminescent organique selon la revendication 1, dans lequel :
le composé représenté par la Formule chimique 1 est un quelconque sélectionné dans le groupe consistant en :

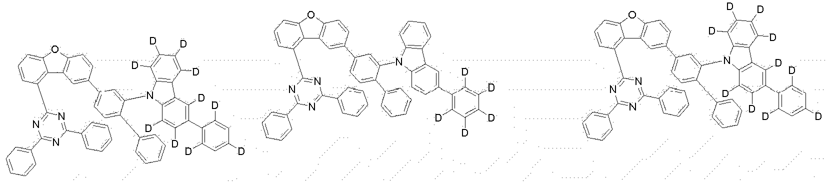

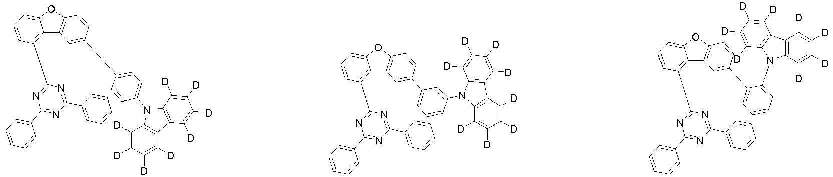

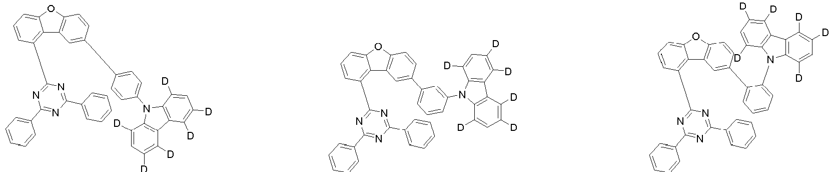

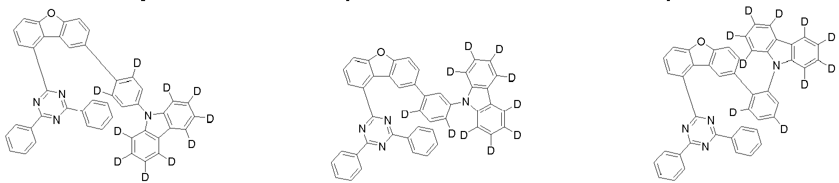

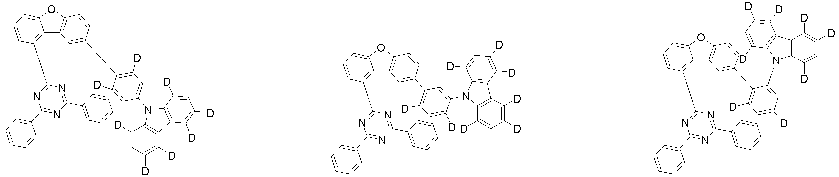

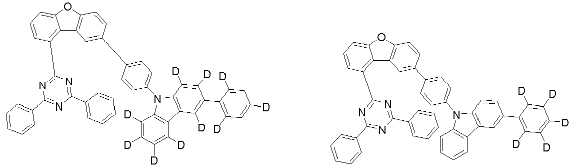

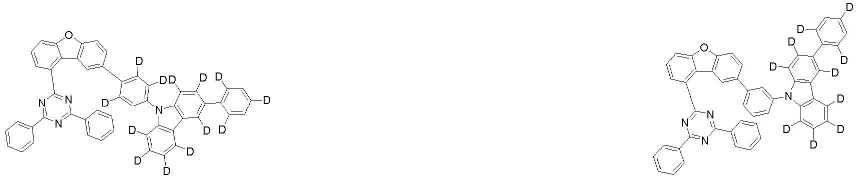

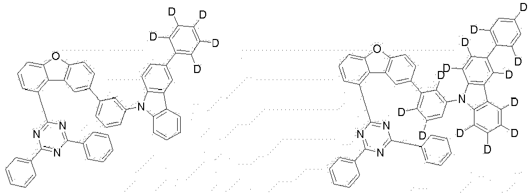

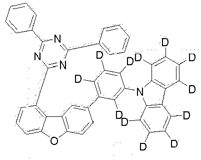

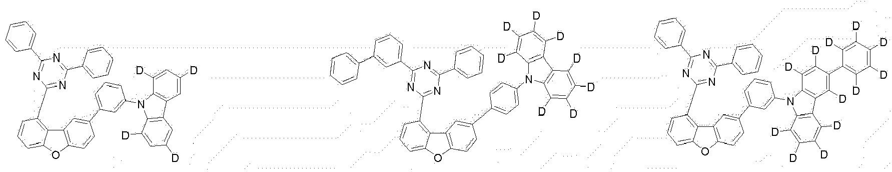

6. Dispositif électroluminescent organique selon la revendication 1, dans lequel :
L₂ et L₃ sont chacun indépendamment une liaison simple ou un phénylène,
dans lequel le phénylène est non substitué ou substitué par au moins un deutérium.

7. Dispositif électroluminescent organique selon la revendication 1, dans lequel :
chaque R₃ est indépendamment hydrogène, ou deutérium.

8. Dispositif électroluminescent organique selon la revendication 1, dans lequel :
le composé représenté par la formule chimique 2-1 est l'un quelconque sélectionné parmi le groupe consistant en : 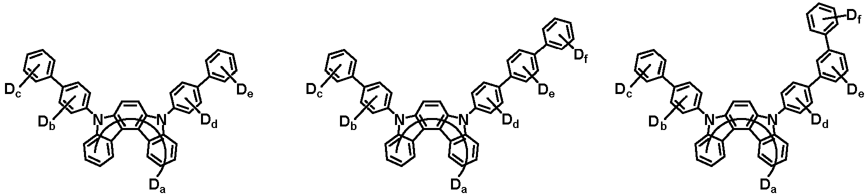 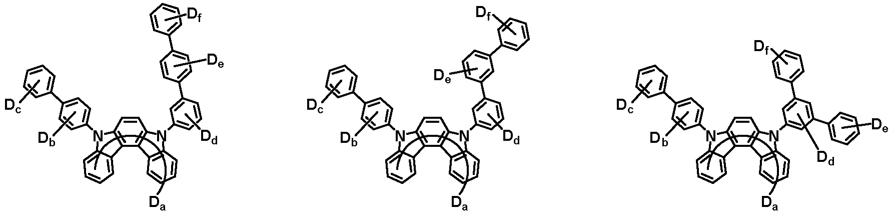 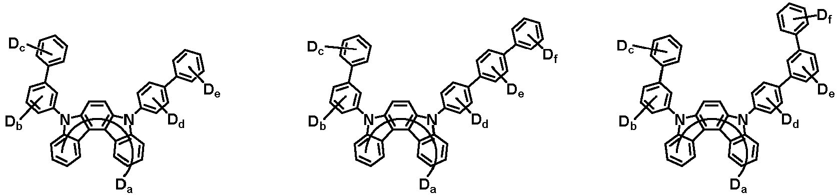 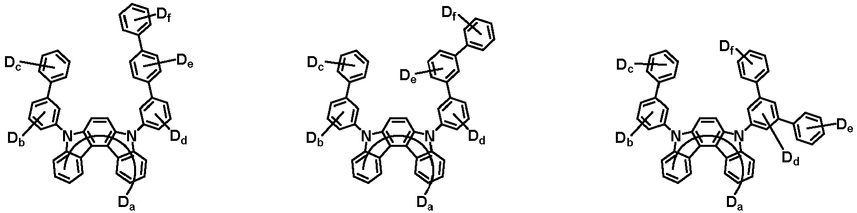 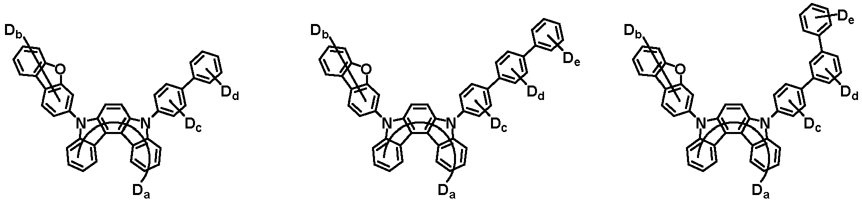 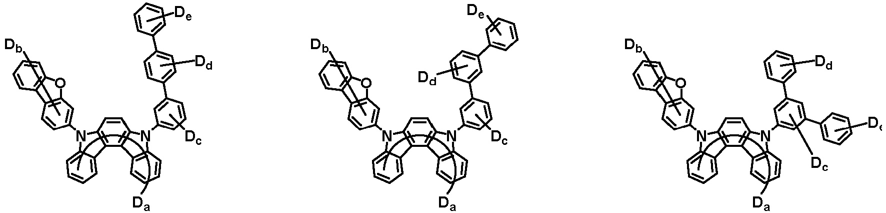 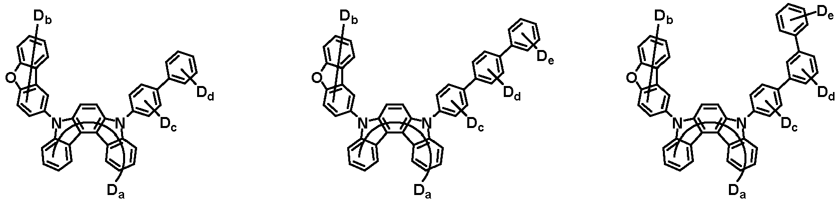 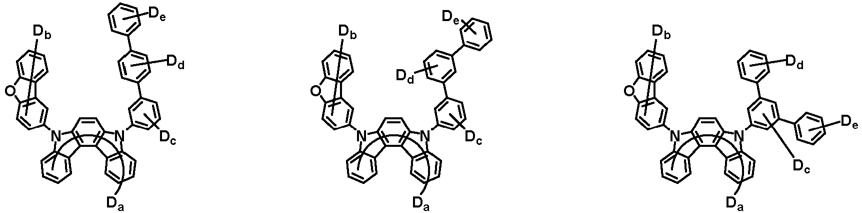 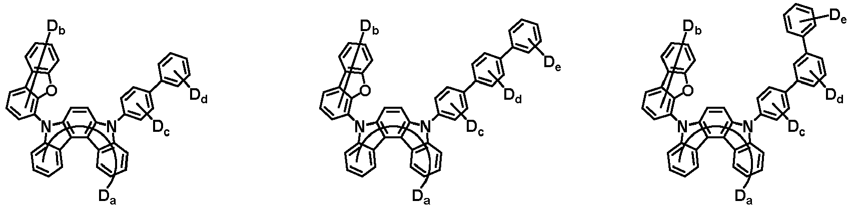 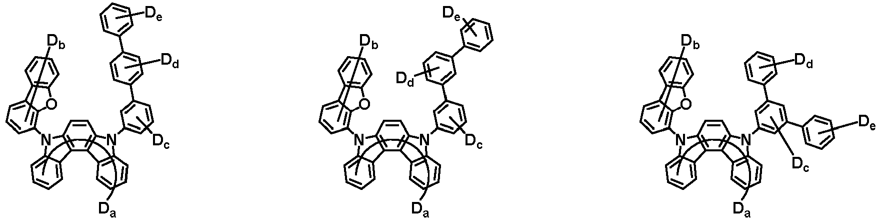 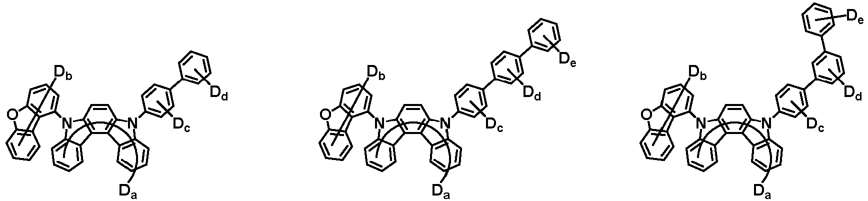 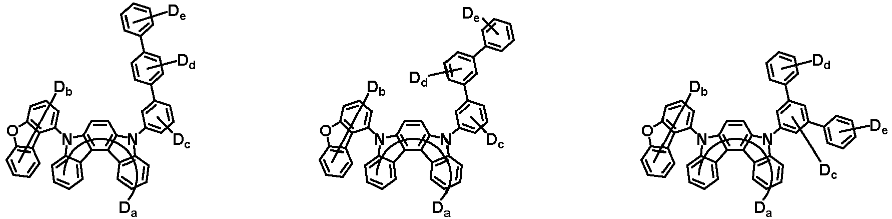 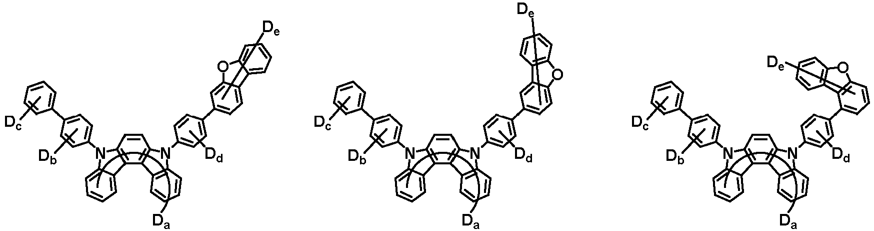 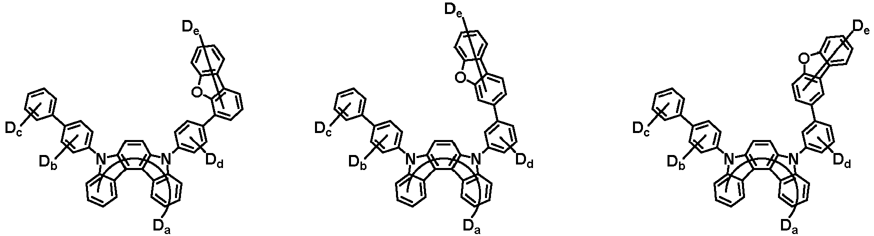 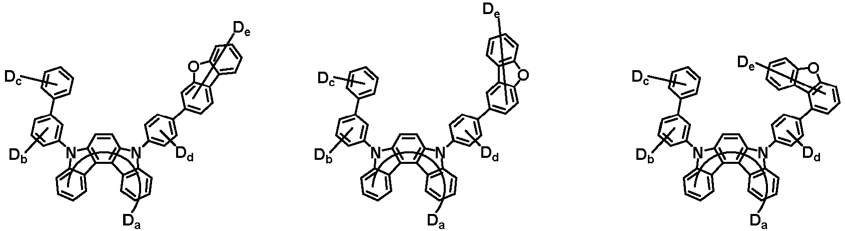 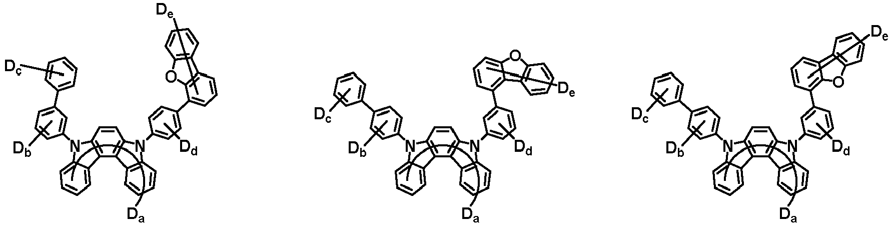 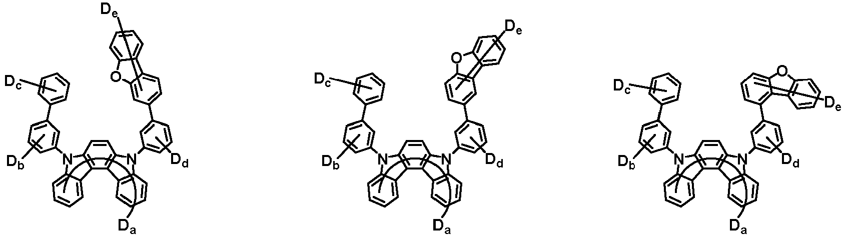 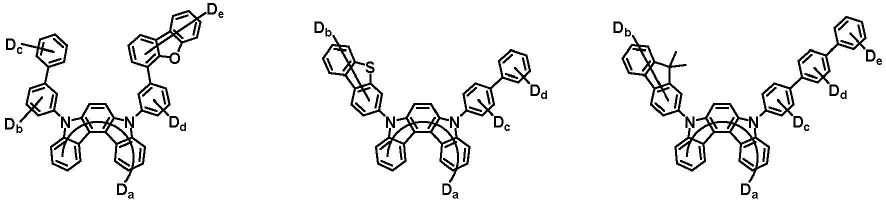 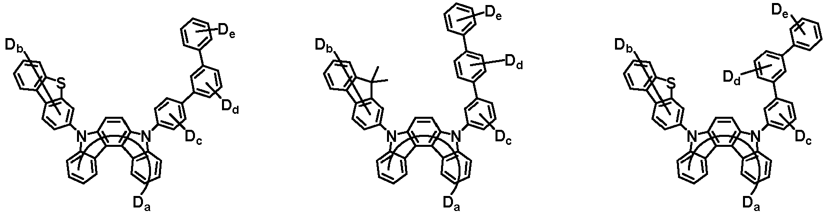 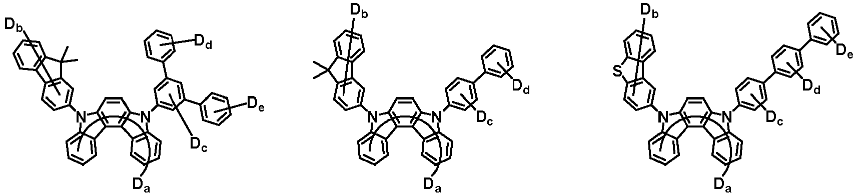 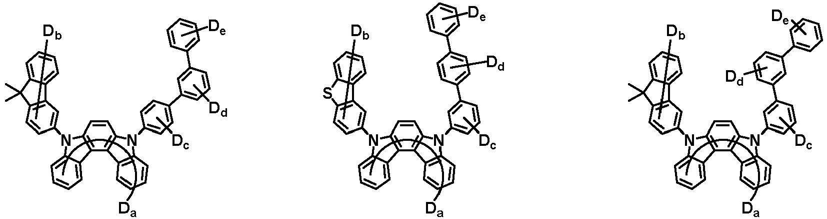 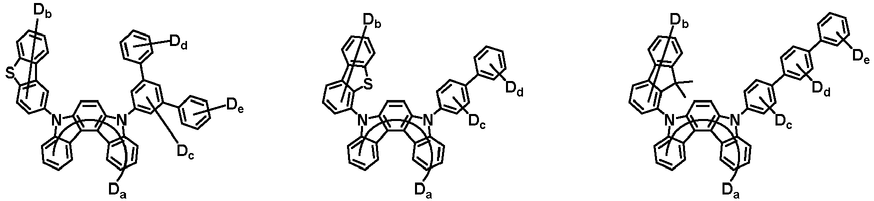 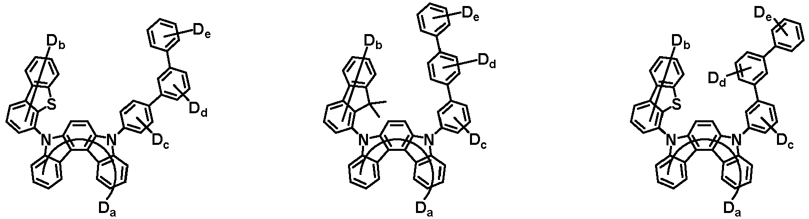 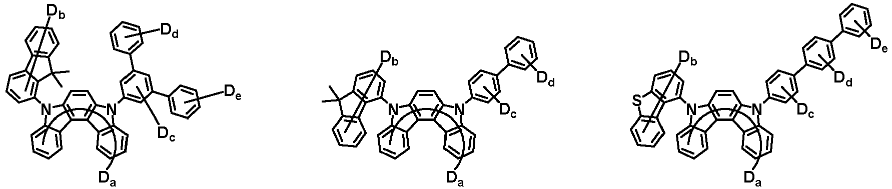 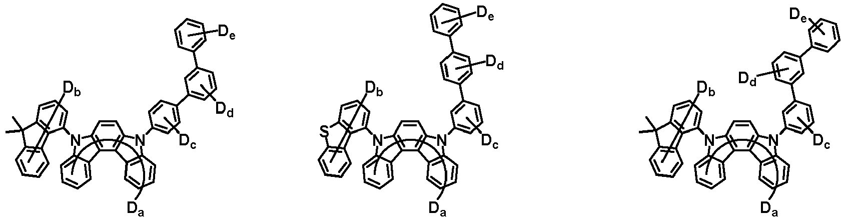 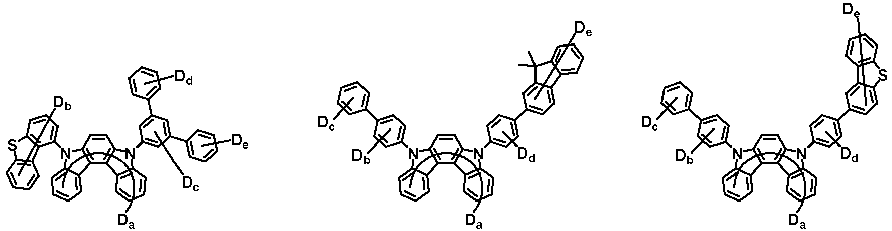 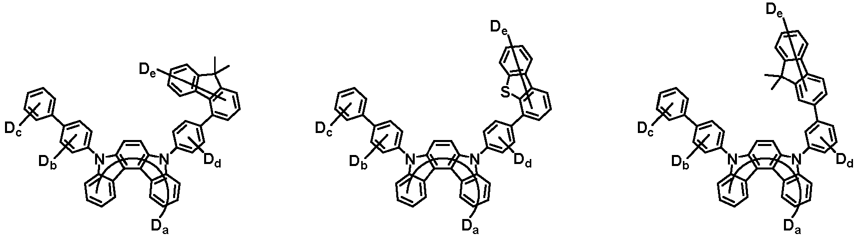 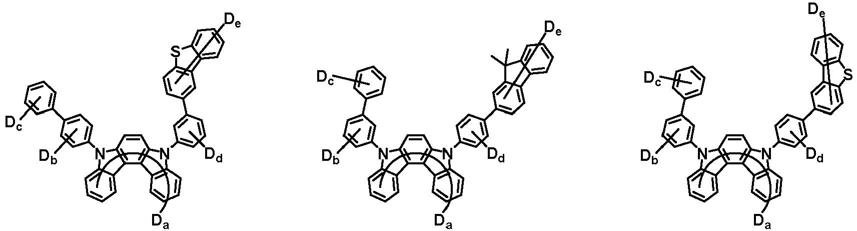 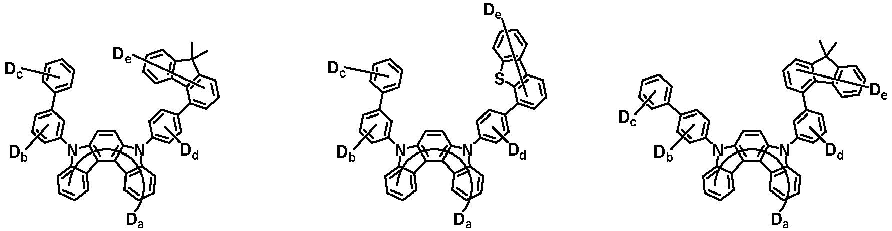 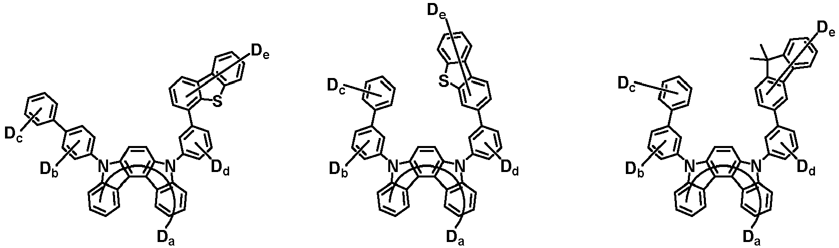 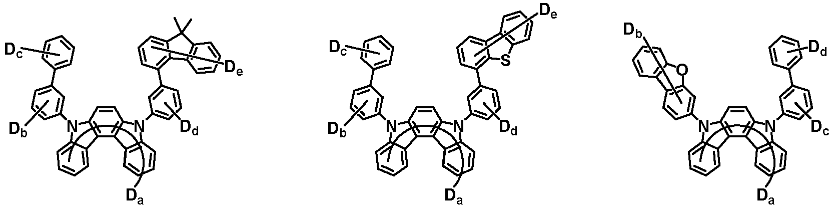
dans lequel, dans le groupe ci-dessus,
a est un nombre entier de 0 à 10,
b est un nombre entier de 0 à 7,
c est un nombre entier de 0 à 5,
d est un nombre entier de 0 à 5,
e est un nombre entier de 0 à 7,
f est un nombre entier de 0 à 5,
à condition que la somme de a à f soit 1 ou plus.
